# EUROPEAN PATENT SPECIFICATION

(11) **EP 0 282 353 B1**
(45) Date of publication and mention of the grant of the patent: **17.03.1993**
(21) Application number: 88302214.7
(22) Date of filing: 14.03.1988
(51) Int. Cl.: G03G 21/00, G03F 7/00, G03B 27/32, G03F 3/04

(54) **Image recording apparatus**
Bildaufnahmegerät
Appareil d'enregistrement d'images

(30) Priority: 13.03.1987 JP 59795/87; 29.05.1987 JP 135371/87; 21.07.1987 JP 182807/87; 01.03.1988 JP 47928/88
(43) Date of publication of application: 14.09.1988
(73) Proprietor: BROTHER KOGYO KABUSHIKI KAISHA, Nagoya-shi, Aichi-ken (JP)
(72) Inventor: Higashiyama, Shunichi, Horita-dori Mizuho-ku Nagoya Aichi-ken (JP); Sagou, Akira, Horita-dori Mizuho-ku Nagoya Aichi-ken (JP); Asano, Yuji, Horita-dori Mizuho-ku Nagoya Aichi-ken (JP); Kuwabara, Satoru, Horita-dori Mizuho-ku Nagoya Aichi-ken (JP); Matsumoto, Yumio, Horita-dori Mizuho-ku Nagoya Aichi-ken (JP); Ueda, Masashi, Horita-dori Mizuho-ku Nagoya Aichi-ken (JP); Takagi, Osamu, Horita-dori Mizuho-ku Nagoya Aichi-ken (JP); Hatta, Naoyuki, Horita-dori Mizuho-ku Nagoya Aichi-ken (JP); Hayashi, Shigeyuki, Horita-dori Mizuho-ku Nagoya Aichi-ken (JP); Sasaki, Ichiro, Horita-dori Mizuho-ku Nagoya Aichi-ken (JP); Itoh, Yosuke, Horita-dori Mizuho-ku Nagoya Aichi-ken (JP); Nakata, Takashi, Horita-dori Mizuho-ku Nagoya Aichi-ken (JP); Ohno, Motoshi, Horita-dori Mizuho-ku Nagoya Aichi-ken (JP); Murata, Takehiko, Horita-dori Mizuho-ku Nagoya Aichi-ken (JP); Makino, Kazumasa, Horita-dori Mizuho-ku Nagoya Aichi-ken (JP); Kobayakawa, Kouji, Horita-dori Mizuho-ku Nagoya Aichi-ken (JP); Sakai, Jun, Horita-dori Mizuho-ku Nagoya Aichi-ken (JP); Akao, Michitoshi, Horita-dori Mizuho-ku Nagoya Aichi-ken (JP); Yamamoto, Takemi, Horita-dori Mizuho-ku Nagoya Aichi-ken (JP)
(74) Representative: Rackham, Stephen Neil

(56) References cited:
- GB-A- 2 201 803
- US-A- 4 399 209
- US-A- 4 440 846
- US-A- 4 624 560
- RESEARCH DISCLOSURE, no. 276, April 1987, pages 226-227, New York, USA : "Hot Roller Fixture For Glossing".
- PATENT ABSTRACTS OF JAPAN, vol. 10, no. 243 (P-489)(2299), 21st August 1986 ; & JP-A-61 73968
- PATENT ABSTRACTS OF JAPAN, vol. 7, no. 238 (P-231)(1383), 22nd October 1983 ; & JP-A-58125074
- PATENT ABSTRACTS OF JAPAN, vol. 10, no. 57 (P-434)(2114), 7th March 1986 ; & JP-A-60201364

## Description

The present invention relates to an image recording apparatus such as an optical printer and a photocopying machine, and more particularly, to a type thereof in which a photosensitive and pressure sensitive medium is light-exposed for forming a latent image thereon, and then the image becomes a visible image upon application of pressure to the sensitive medium.

In a conventional transfer type image recording method, a photosensitive and pressure sensitive medium or sheet and a developer sheet are used. The photosensitive and pressure sensitive sheet includes a base substrate and microcapsules carried on the base substrate. On the other hand, the developer sheet includes a substrate and a developer material such as organic acid coated thereon. Each of the microcapsules encapsules therein chromogenic material (dye precursor or color former), photo-curing resin, and photo polymerization initiator. When the sensitive sheet is subjected to light exposure through an original, light exposed microcapsules become solidified due to photo-curing of the photo curable resin, so that a latent image is formed on the sensitive sheet. When such sensitive sheet is overlapped with the developer sheet, and the two sheets are subjected to pressure by pressure rollers, electromagnetic force, or ultrasonic wave, unexposed microcapsules (non- photo cured microcapsules) are ruptured, so that the chromogenic material in the microcapsules is reacted with the developer material. As a result, a visible image is formed on the developer sheet. In order to promote visuality of the visible image, heat is applied to the image formed developer sheet by means of a thermal fixing unit. The above-mentioned photosensitive/pressure sensitive sheet and the developer sheet are disclosed in U.S. Patent 4,399,209.

In the above transfer type recording method, the developer material is coated on a separate substrate as a separate developer or copying sheet in addition to the photosensitive/pressure sensitive sheet. In another image recording method, such separate developer sheet is not required. Specifically, a photosensitive/pressure sensitive sheet provides self-coloring function in which both above-described microcapsules and developer materials are carried on a substrate. With the structure, upon pressure application, non exposed microcapsules are ruptured, and chromogenic material flowed out of the ruptured microcapsules are reacted with the developer matrerial also carried on the sensitive sheet, to thereby provide a visible image on the sensitive sheet. Such self-contained type recording medium is disclosed in U.S. Patent 4,440,846.

According to such types of recording mediums, ambient temperature and humidity may affect photo-sensitivity and developability, and therefore, there are temperature and humidity ranges for optimumly provide photo-sensitivity and developability of these mediums. That is, for example, the temperature should be in an allowable range of from 5 to 35°C, and the humidity should be in an allowable range of from 20 to 80 %. The allowable range is, in general, determined by a ralative relationship between temperature and humidity. If humidity is remarkably low, a high tempetature such as 50°C is allowable.

If the image recording apparatus is operated at a condition outside these ranges, for example, at an extremely high temperature and a high humidity, a visible image appearing on the developer sheet and formed by the pressure unit may be further transferred back to the photo sensitive/pressure sensitive sheet, and therefore, clear visible image may not be obtainable in the developer sheet in case of the transfer type recording medium. Further, the developer sheet may be adhered to each other, and the developer sheet may not be easily separated from the sensitive sheet after pressure application thereto. On the other hand, in case of the transfer type recording medium, if the sensitive sheet is used at an extremely low temperature condition outside the allowable temperature range, chromogenic material may not be easily flowed to degrade its transfer onto the developer sheet upon pressure application thereto. As a result, low density visible image is provided, and clear image may not be attainable.

Similarly, in case of the self-contained type recording medium, if the sensitive sheet is used at an extremely high temperature and a humidity conditions those outside the allowable range, image on the sheet is transferred to a pressure roller surface or other member in pressure contact therewith. As a result, visible immage unevenness or irregularity may occur, to thus degrade resultant visible image.

According to this invention an image recording apparatus including a light source for irradiating photo-sensitive and pressure sensitive recording medium for forming a latent image on it and a pressure unit for developing an image on the photo-sensitive and pressure sensitive recording medium; characterised in that the apparatus includes control means for controlling the temperature and humidity condition of the environment around the photo-sensitive and pressure sensitive recording medium so that, development of the recording medium is carried out under acceptable conditions.

Many examples of apparatus in accordance with this invention will now be described with reference to the accompanying drawings; in which:-
Figure 1 is a schematic view showing an image recording apparatus which incorporates a cooling unit according to a first embodiment of this invention;
Figure 2 is a schematic view showing the cooling unit shown in Figure 1;
Figure 3 is a schematic view showing a cooling unit according to a second embodiment of this invention;
Fig. 4 is a schematic view showing a cooling unit according to a third embodiment of this invention;
Figs. 5 thru 40 show a unit for controlling humidity of a developer sheet according to various embodiments of this invention; and in which;

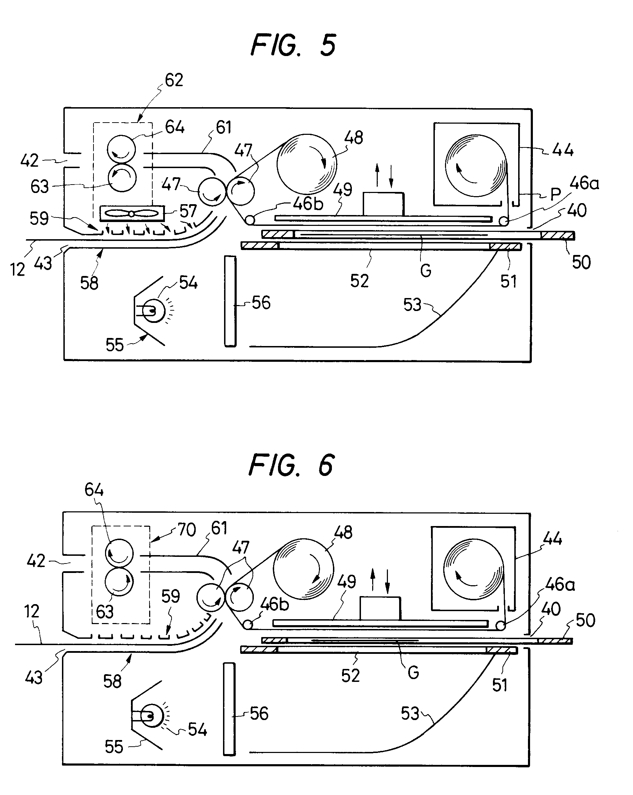

Fig 5 is a schematic view showing an image recording apparatus which incorporates a humidity control unit according to a fourth embodiment of this invention;
Fig. 6 is a schematic view showing an image recording apparatus which incorporates a humidty control unit according to a fifth embodiment of this invention;

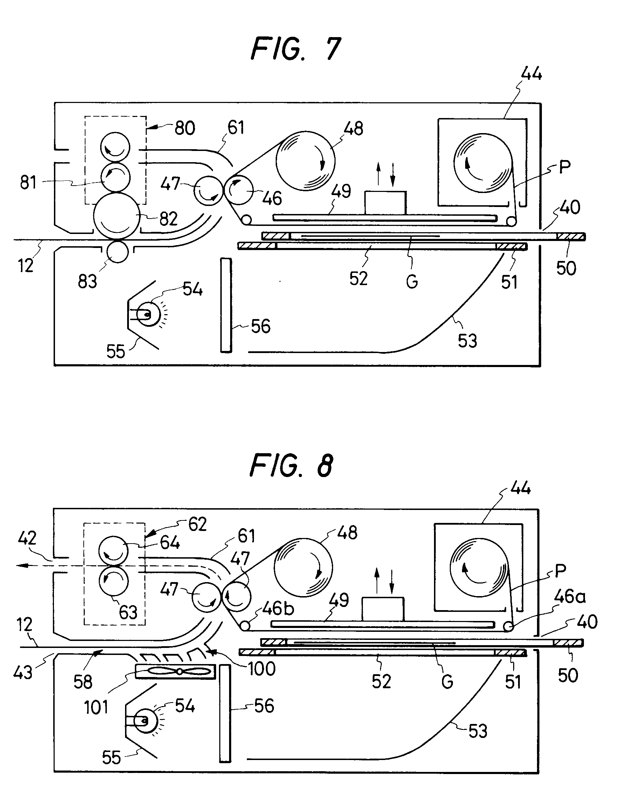

Fig. 7 is a schematic view showing an image recording apparatus which incorporates a humidty control unit according to a sixth embodiment of this invention;
Fig. 8 is a schematic view showing an image recording apparatus which incorporates a humidity control unit according to a seventh embodiment of this invention;

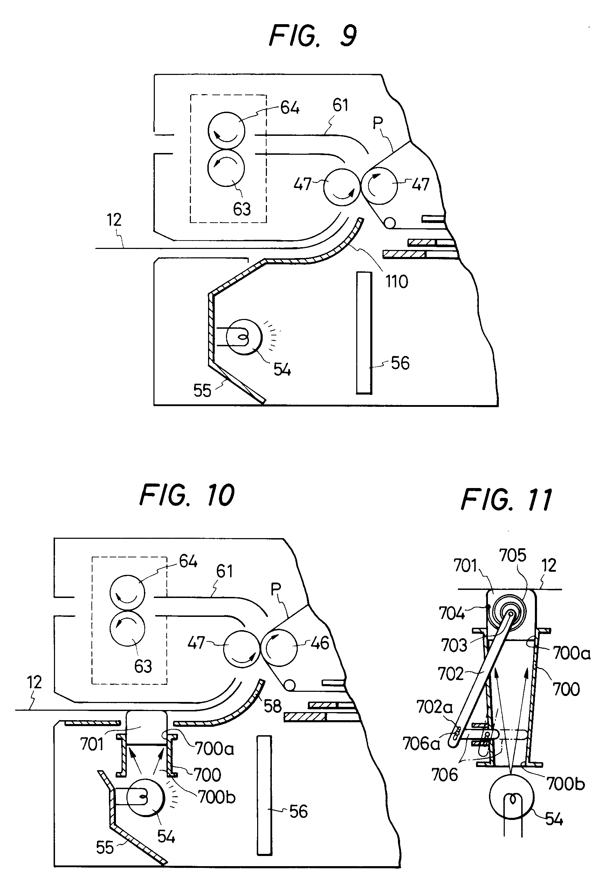

Fig. 9 is a schematic view showing an image recording apparatus which incorporates a humidity control unit according to an eighth embodiment of this invention;
Fig. 10 is a schematic view showing an image recording apparatus which incorporates a humidity control unit according to a ninth embodiment of this invention;
Fig. 11 is a detailed view showing the humidity control unit shown in Fig. 10;

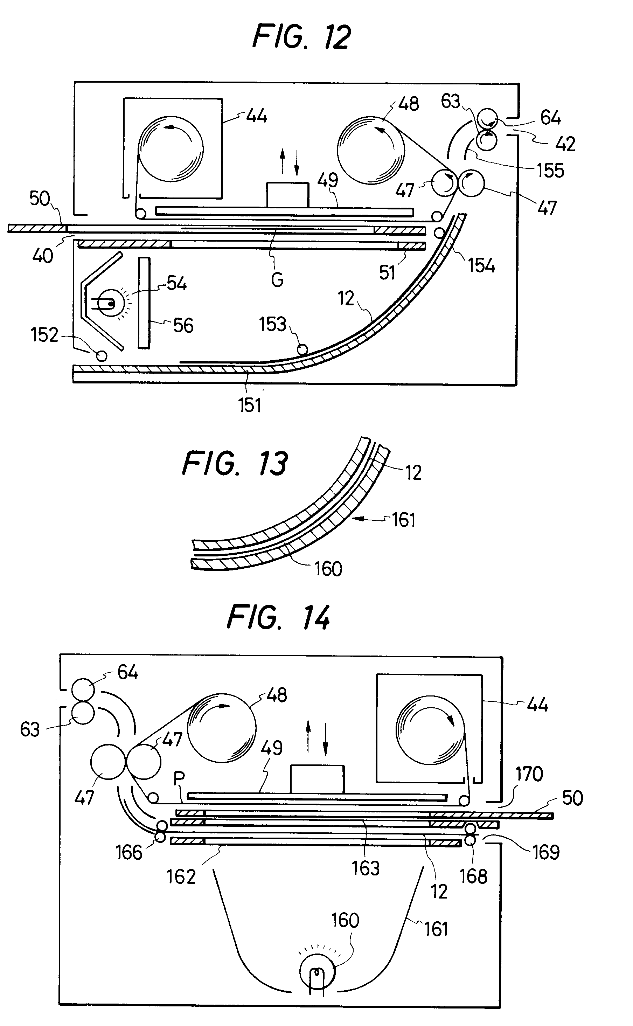

Fig. 12 is a schematic view showing an image recording apparatus which incorporates a humidity control unit according to a tenth embodiment of this invention;
Fig. 13 is a cross-sectional view showing a diffusion plate which is a humidity control unit according to an eleventh embodiment of this invention;
Fig. 14 is a schematic view showing an image recording apparatus which incorporates a humidity control unit according to a twelefeth embodiment of this invention;

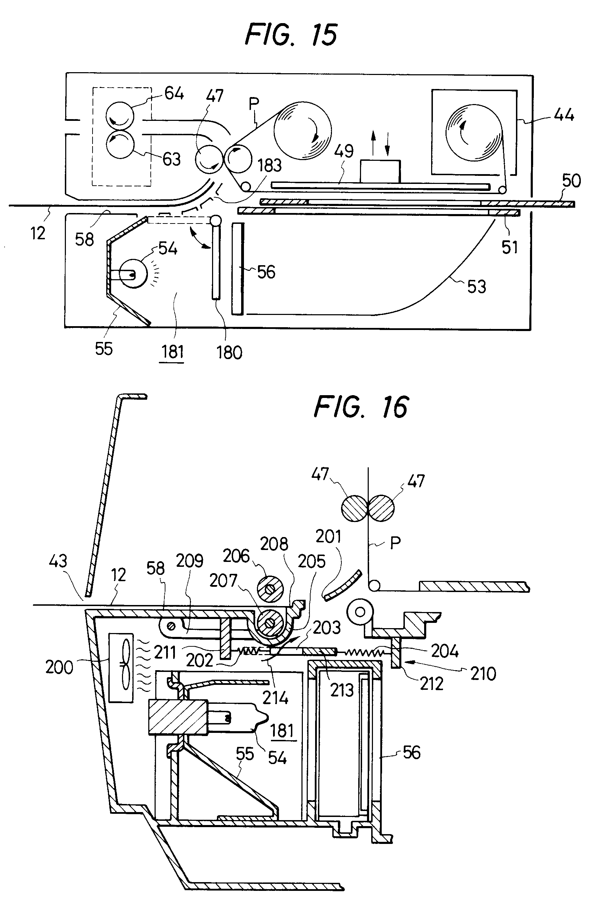

Fig. 15 is a schematic view showing an image recording apparatus which incorporates a humidity control unit according to a thirteenth embodiment of this invention;
Fig. 16 is a schematic view showing a guide portion which guides travel of a developer sheet according to a fourteenth embodiment of this invention;

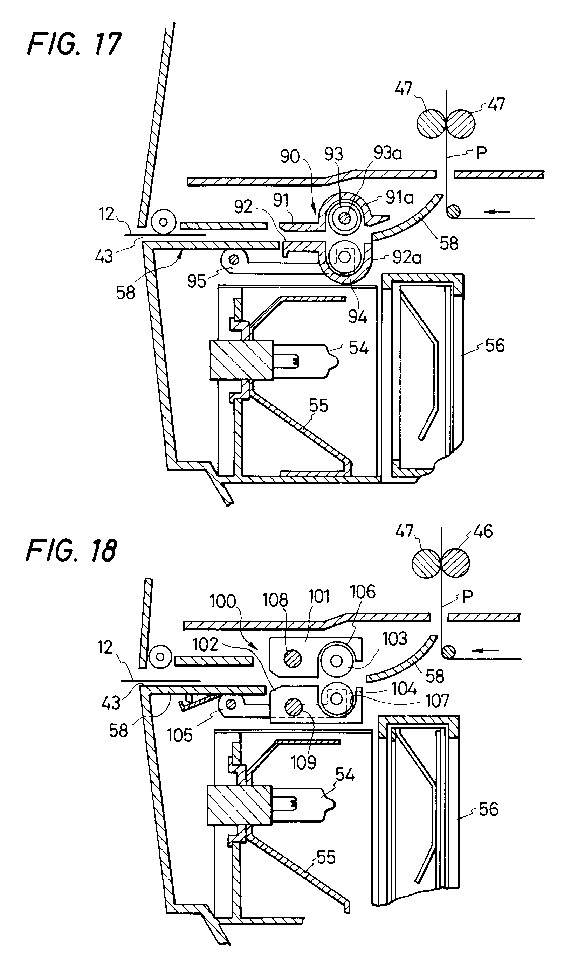

Fig. 17 is a schematic view showing a guide portion which guides travel of a developer sheet according to a fifteenth embodiment of this invention;
Fig. 18 is a schematic view showing a guide portion which guides travel of a developer sheet according to a sixteenth embodiment of this invention;

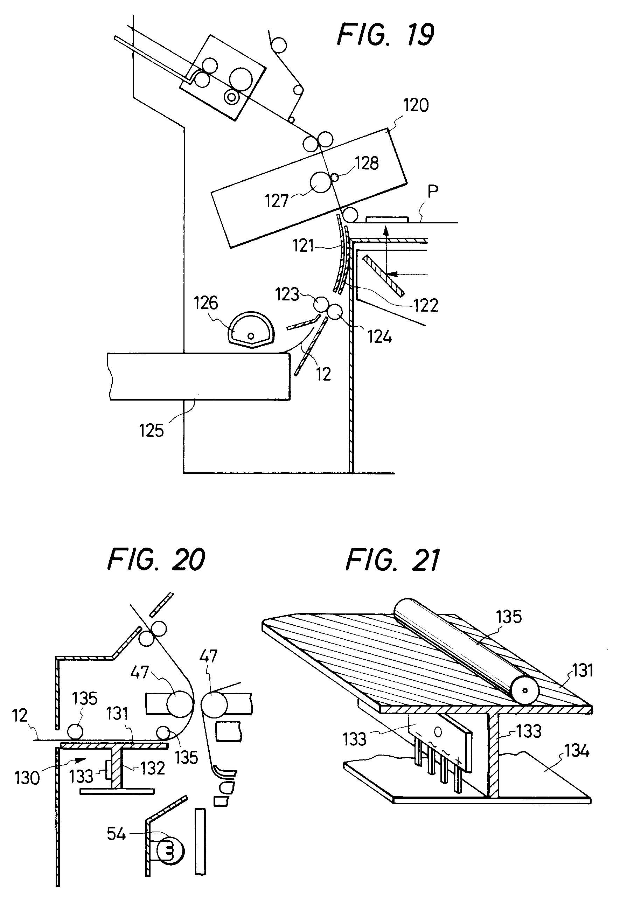

Fig. 19 is a schematic view showing a guide portion which guides travel of a developer sheet according to a seventeenth embodiment of this invention;
Fig. 20 is a schematic view showing a guide portion which guides travel of a developer sheet according to an eighteenth embodiment of this invention;
Fig. 21 is an enlarged perspective view showing the guide portion shown in Fig. 20;

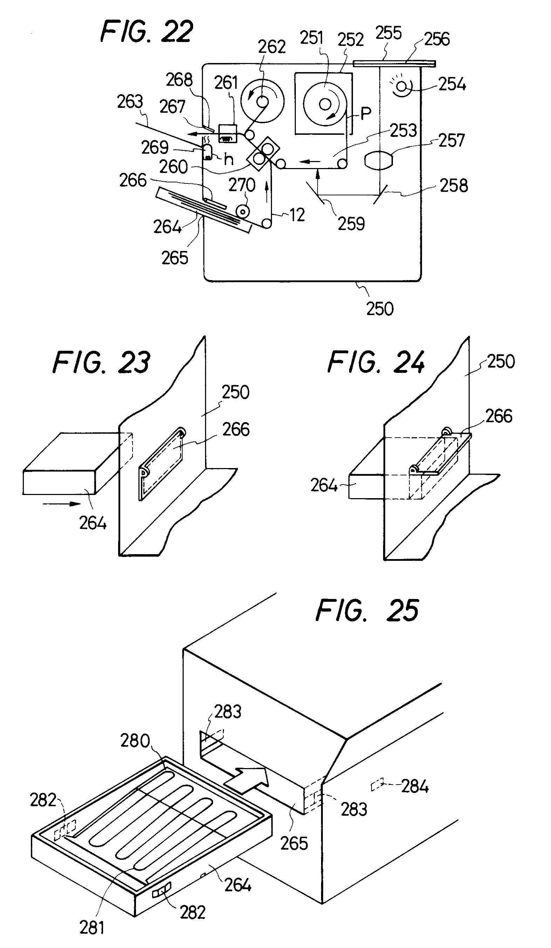

Fig. 22 is a schematic view showing an image recording apparatus which detachably support a developer sheet cassette according to a nineteenth embodiment of this invention;
Fig. 23 is an enlarged view showing a cassette insertion hole in the recording apparatus shown in Fig. 22;
Fig. 24 is an enlarged view showing a state wherein the cassette is inserted into the insertion hole shown in Fig. 23;
Fig. 25 is a perspective view showing a developer sheet cassette and a cassette insertion hole formed in a main frame of an image recording apparatus according to a twentieth embodiment of this invention;

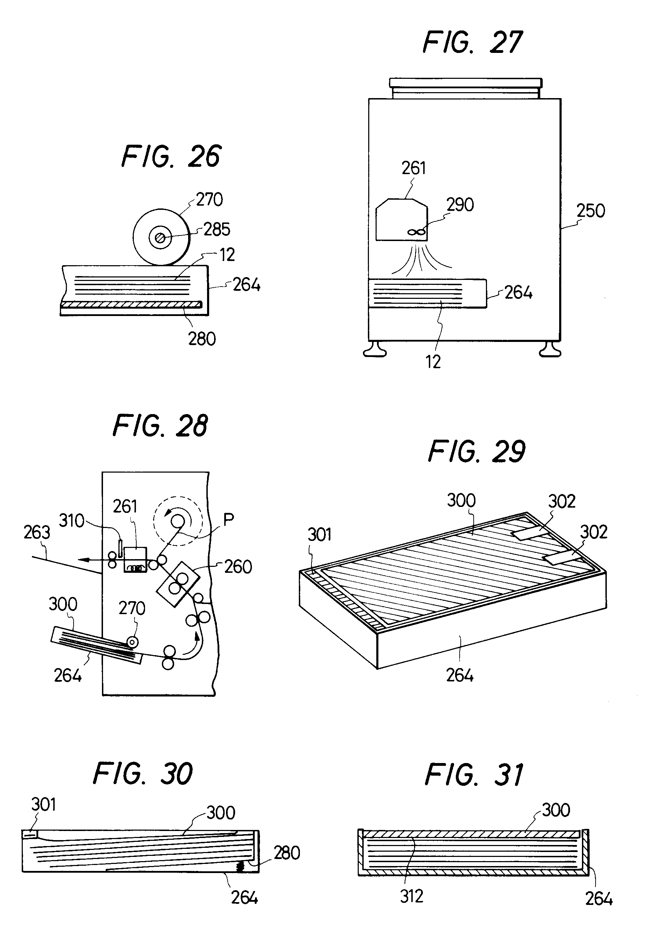

Fig. 26 is a side view showing a sheet cassette and a sheet feed roller according to a twenty-first embodiment of this invention;
Fig. 27 is a schematic view showing an arrangement of a developer sheet cassette and a thermal image fixing unit according to a twenty-second embodiment of this invention;
Fig. 28 is a schematic view showing an image recording apparatus which employs a moisture absorbing member according to a twenty-third embodiment of this invention;
Fig. 29 is a perspective view showing a developer sheet cassette covered with the moisture absorbing sheet shown in Fig. 28;
Fig. 30 is a cross-sectional view showing the developer sheet cassette shown in Fig. 29;
Fig. 31 is a cross-sectional view showing a moisture absorbing member disposed on a sheet cassette according to a modified embodiment;

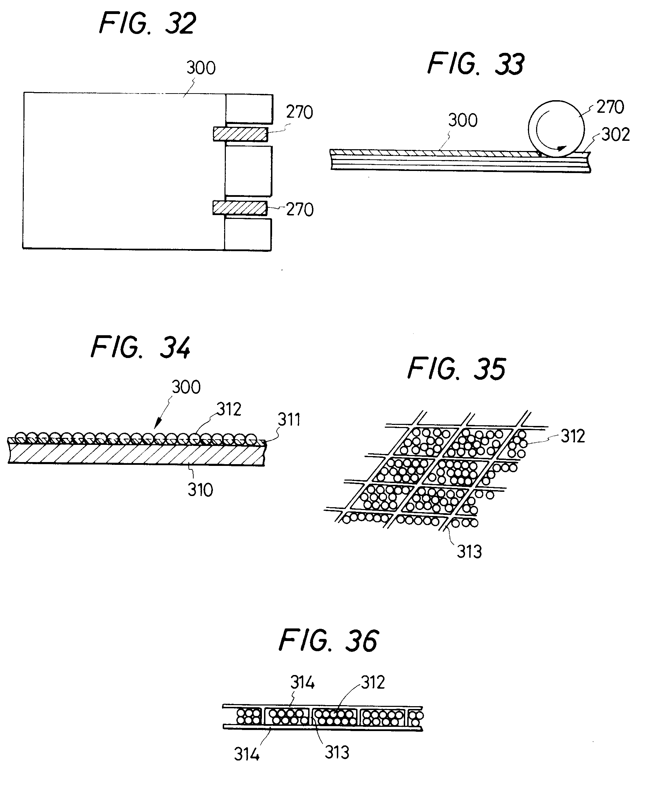

Fig. 32 is a plan view of showing the moisture absorbing member and sheet feed rollers;
Fig. 33 is a side view of Fig. 32;
Fig. 34 is a cross-sectional view showing a moisture absorbing sheet member;
Fig. 35 is a perspective view showing the moisture absorbing sheet member;
Fig. 36 is a cross-sectional view showing a moisture absorbing sheet member in a modified form;

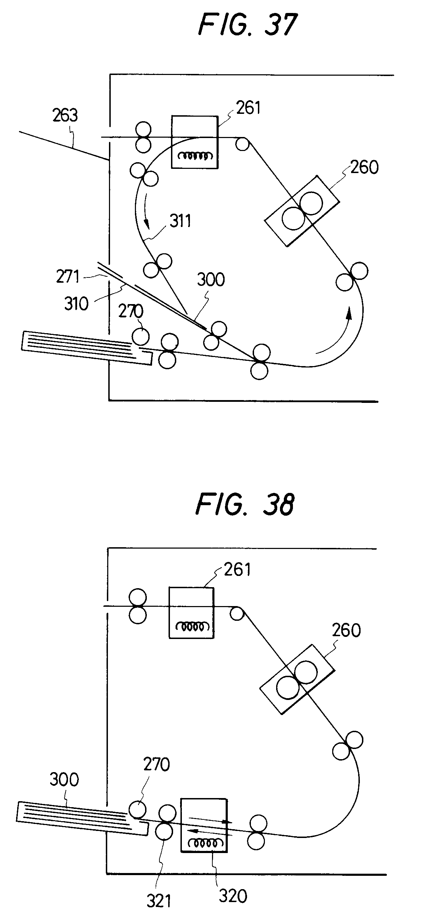

Fig. 37 is a schematic view showing a partial image recording apparatus which employs a moisture absorbing sheet member according to a twenty-fourth embodiment of this invention;
Fig. 38 is a schematic view showing a partial image recording apparatus which employs a moisture absorbing sheet member according to a twenty-fifth embodiment of this invention;

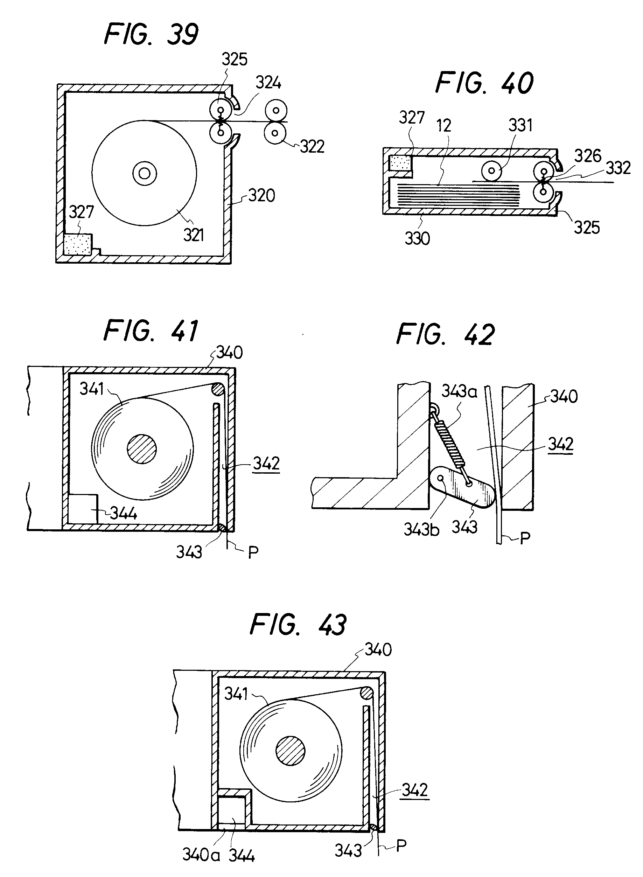

Fig. 39 is a cross-sectional view showing a cassette for accommodating a developer sheet roll according to a twenty-sixth embodiment of this invention;
Fig. 40 is a cross-sectional view showing a cassette for accommodating a cut developer sheets according to a twenty-seveth embodiment of this invention;
Fig. 41 is a cross-sectional view showing a cassette for accommodating a photo-sensitive/pressure sensitive sheet roll according to a twenty-eighth embodiment of this invention;
Fig. 42 is an enlarged view showing a sealing means for use in the cassette shown in Fig. 41;
Fig. 43 is a cross-sectional view showing a cassette for accommodating a photo-sensitive/pressure sensitive sheet roll according to a twenty-ninth embodiment of this invention;

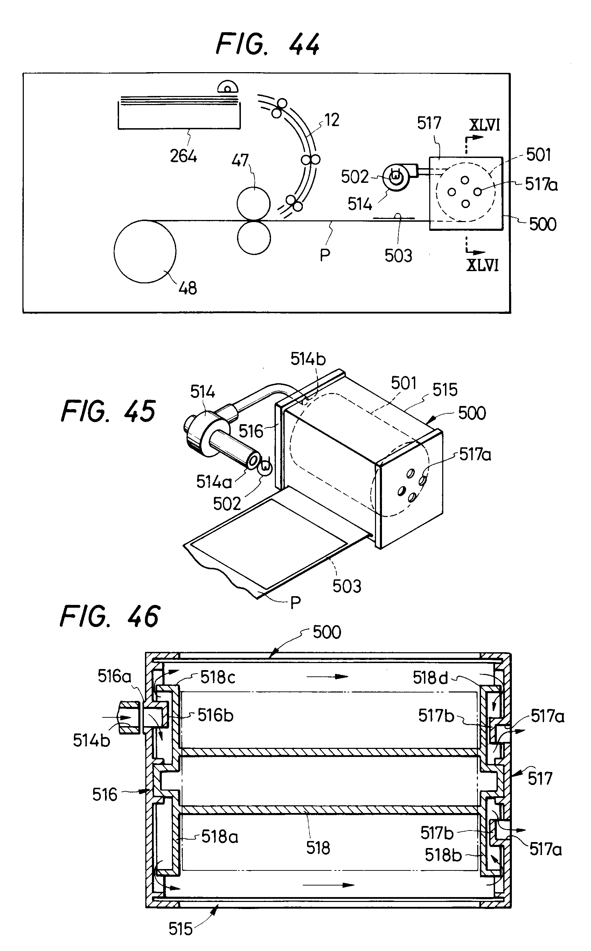

Figs. 44 thru 48 show various embodiments showing means for heating and moisture removing a photo-sensitive/pressure sensitive sheet according to this invention; and in which;
Fig. 44 is a schematic view showing an image recording apparatus according to a thirtieth embodiment of this invention;
Fig. 45 is a perspective view showing a sensitive sheet roll cassette used in an embodiment shown in Fig. 44;
Fig. 46 is a cross-sectional view showing the sensitive sheet roll cassette shown in Fig. 45;

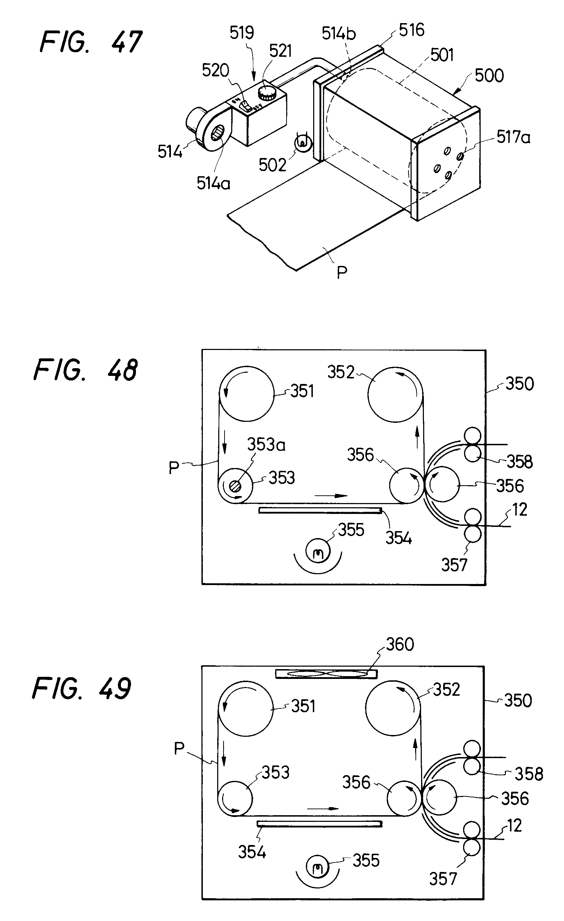

Fig. 47 is a perspective view showing a sensitive sheet roll cassette to which a modification is made on the embodiment shown in Fig. 45;
Fig. 48 is a schematic view showing an image recording apparatus according to a thirty-first embodiment of this invention;
Fig. 49 is a schematic view showing an image recording apparatus according to a thirty-second embodiment of this invention;

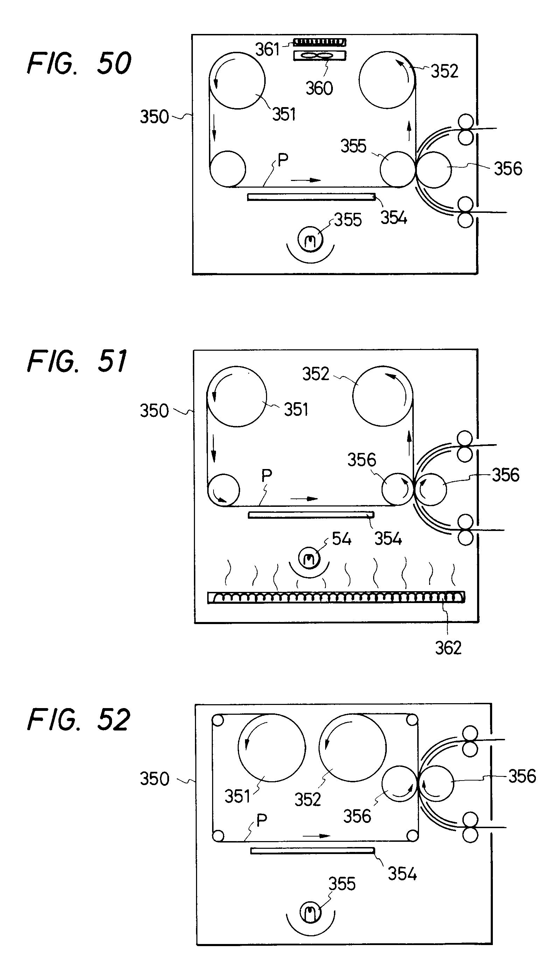

Fig. 50 is a schematic view showing an image recording apparatus according to a thirty-third embodiment of this invention;
Fig. 51 is a schematic view showing an image recording apparatus according to a thirty-fourth embodiment of this invention;
Fig. 52 is a schematic view showing an image recording apparatus according to a thirty-fifth embodiment of this invention;

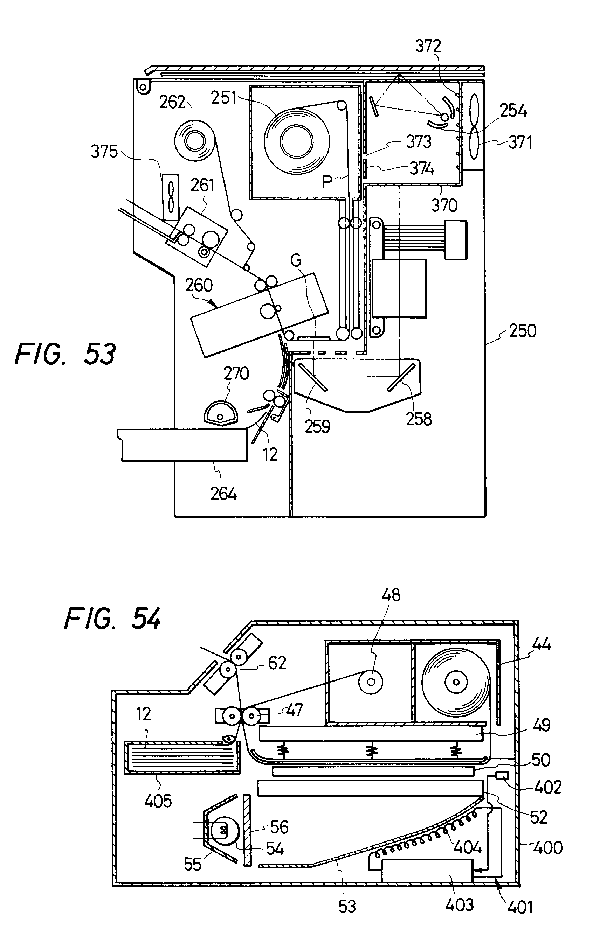

Figs. 53 to 56 show various embodiments for controlling temperature and humidity of an overall internal space of the image recording apparatus, and in which;
Fig. 53 is a schematic view showing an image recording apparatus provided with heating and moisture removing means according to a thirty-sixth embodiment of this invention;
Fig. 54 is a schematic view showing an image recording apparatus provided with heating and moisture removing means according to a thirty-seventh embodiment of this invention;

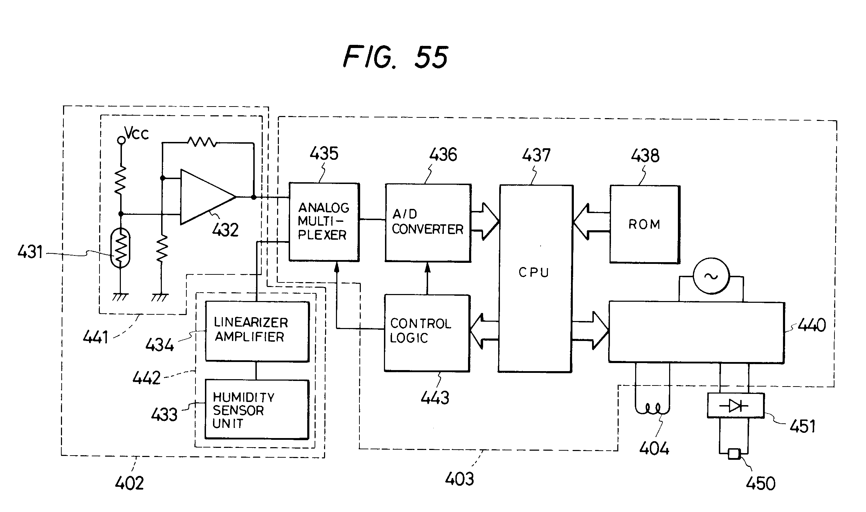

Fig. 55 is a block diagram incorporated into an emboidment shown in Fig. 54;

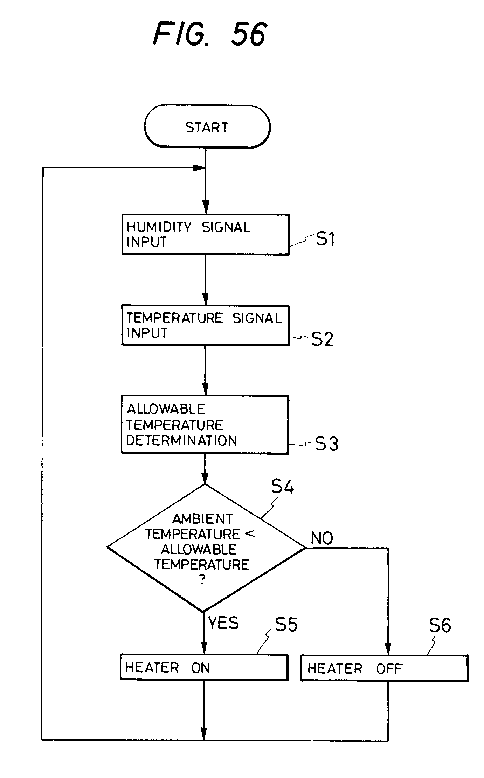

Fig. 56 is a flow-chart showing a function attendant to the embodiment shown in Fig. 54;

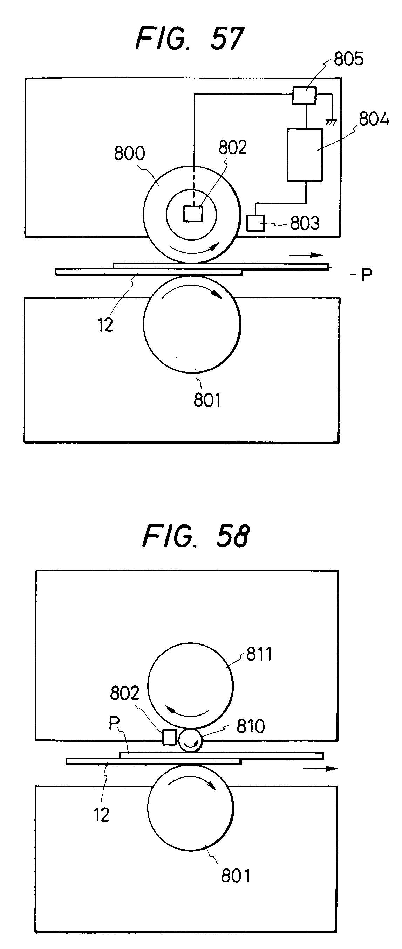

Fig. 57 is a schematic view showing a heat control unit disposed at a pressure unit according to a thirty-eighth embodiment of this invention; and,
Fig. 58 is a schematic view showing a heat control unit according to a thirty-ninth embodiment of this invention.

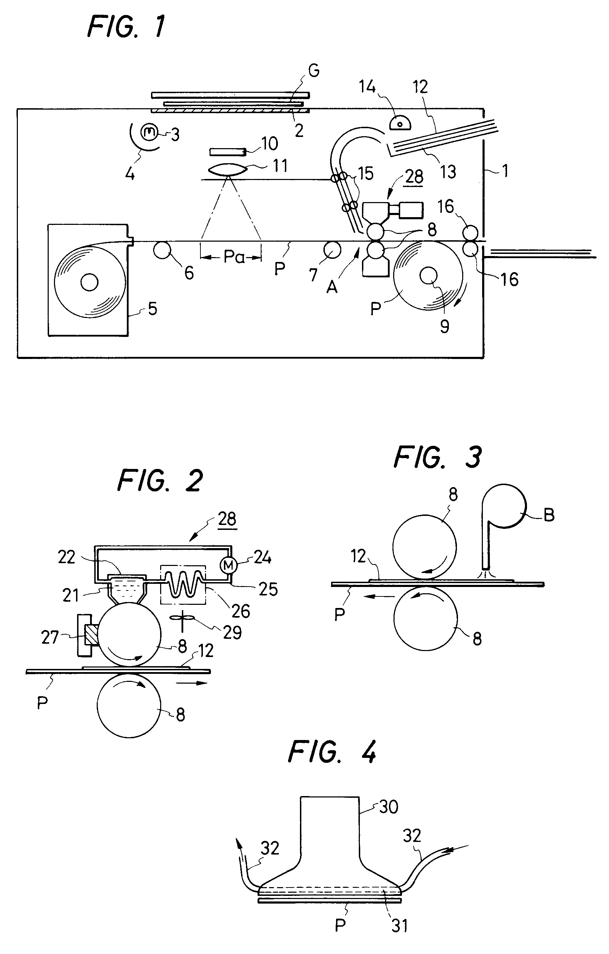

A copying machine according to one embodiment of this invention will be described with reference to Figs. 1 and 2. This embodiment and modified embodiments as those shown in Figs. 3 and 4 concern copying machines which inevitably provide a temperature higher than allowable temperature range of photo sensitive and pressure sensitive sheet (hereinafter, simply referred to as "sensitive sheet").

Fig. 1 is a schematic illustration showing a photo copying machine. The copying machine has a casing 1 whose upper portion is provided with a transparent supporting glass 2 on which an original G is mounted. Below the original support glass 2, a light source 3 and a reflection plate 4 are provided to emit light to the original. At a lower portion of the casing 1, a sheet cartridge 5 is disposed in which a web-like sensitive sheet P is accommodated in its rolling state. The sheet P includes a base substrate and a plurality of microcapsules carried thereon at a predetermined density. Each of the microcapsules encapsules therein chromogenic material (dye precursor or color former), photo-curing resin and photo polymerization initiator.

A take-up roller 9 is disposed in the casing 1 and spaced away from the sheet cartridge 5. The sensitive sheet P bridged between the cartridge 5 and the take-up roller 9 is supported by feed rollers 6 and 7 defining a predetermined photo exposure space therebetween which space generally corresponds to a size of the original G. Further, a pair of pressure rollers 8 are disposed at the downstream side of the feed roller 7. The pair of rollers 8 includes an upper and lower rollers and serve as one of the components of a pressure unit A. Upon rotation of the take-up roller 9 in clockwise direction in Fig. 1, the sensitive sheet P is drawn out of the sheet cartridge 5 and is transported to a photo exposure position.

As shown in Fig. 2, a cooling medium case 22 which accommodates a cooling medium 21 is disposed above an upper portion of the upper pressure roller 8. The case 22 has a bottom wall having an arcuate cross-section, so that the bottom wall is in slide contact with the upper roller upon rotation thereof. Therefore, the cooling medium 21 accommodated in the case 22 cools the pressure roller 8 to a temperature, for example, not more than 30°C. The case 22 is connected to a circulation pump 24 through a pipe 25. Further, a cooling portion 26 is provided between the pump 24 and the case 22 for positively cooling the cooling medium. Therefore, the cooling medium 21 in the case 22 is recirculated, and cooled cooling medium 21 is supplied to the case 22. According to this embodiment, the pipe 25 is meandered to prolong its length, and a blower 29 is used to apply cooling air to the meandered portion 26.

Therefore, a cooling system is provided by the cooling medium 21, the cooling medium case 22, and the cooling portion 26 for cooling the pressure roller 8. Further, a felt material 27 is disposed in slide contact with the pressure roller 8. The felt material 27 is positioned upstream of the cooling case 22 in circumferential direction of the pressure roller 8. If foreign substances are adhered to the outer peripheral surface of the pressure roller 8, these foreign objects can be removed by the felt material 27.

Below the original support stand 2, disposed are a shutter 10 for controlling light exposing period and a condensing lens 11 for forming image at a imaging zone Pa on the sensitive sheet P by using a light reflected from the original G. Further, at one side portion in the casing 1, a sheet cassette 13 is disposed for storing and supplying a plurality of developer sheets 12. Each developer sheet 12 carries developer material thereon which is reacted with the chromogenic materials contained in the microcapsules carried on the sensitive sheet P. Upon this reaction, color image is formed on the developer sheet 12.

The developer sheet 12 in the sheet cassette 13 is supplied over the sensitive sheet P in facial contact therewith through a sheet supply roller 14 disposed at a feed out end portion of the cassette 13 and two transferring rollers 15 disposed at downstream side of the sheet supply roller 14. These sheets 12 and P are overlapped with each other and are subjected to compression when passing through the pressure rollers 8. Upon application of the compression, the non-exposed microcapsules on the sensitive sheet P are ruptured, so that chromogenic material in the non-exposed microcapsule is exposed and reacted with the developer material of the developer sheet 12, while other microcapsules already exposed at the exposure zone Pa are not ruptured because of curing of the photo-curable resin contained therein. As a result, an image corresponding to the original G is formed in the developer sheet. The developer sheet 12 formed with the picture image is further passed through an image fixing rollers (heat rollers) 16 disposed at downstream side of the pressure rollers 8, and are discharged out of the copying machine.

Operation of the copying machine according to this embodiment will be described.

The sensitive sheet P drawn out of the cartridge 5 by a predetermined length is subjected to light exposure at the exposing zone Pa. Thereafter, the developer sheet 12 stored at the sheet cassette 13 is supplied through the supply rollers 14 and the transferring rollers 15 and is overlaid onto the running sensitive sheet P travelled from the exposing zone Pa. These two overlapping sheets 12 and P pass through the pressure rollers 8 for applying compression to the sheets. Upon pressure application, the non-exposed microcapsules are ruptured and the chromogenic materials contained therein are reacted with the developer material of the developer sheet 12, so that an image is formed at the developer sheet 12.

In this case, since the pressure rollers 8 are cooled by the cooling medium 21, the sensitive sheet P and the developer sheet 12 are also cooled. Therefore, any detrimental effect such as image transfer from the developer sheet to the pressure roller or to the sensitive sheet can be obviated, after the image is formed on the developer sheet. As a result, the image formed on the developer sheet is stabilizingly fixed at the image fixing roller 16, and is discharged from the copying machine.

A second embodiment according to this invention will be described with reference to Fig. 3. In the second embodiment, instead of the cooling medium 21, cooling case 22, the circulation pump 24 and the pipe 25 those used in the first embodiment, a blower B is disposed at the immediately upstream side of the pressure rollers 8 for blowing cooling air to the overlapping sheets P and 12.

Further, according to a third embodiment shown in Fig. 4, an ultrasonic vibration piece is used as a pressure unit, and a horn 30 is provided which is in direct contact with the sensitive sheet P. The horn 30 is formed with a through hole 31 through which a cooling pipe 32 extends. The cooling pipe 32 allows cooling water to pass therethrough, so that the horn 30 is cooled, to thus cool the sheet P. Incidentally, the embodiments shown in Figs. 1 thru 4 generally uses transfer type imaging sheet wherein the developer material is coated on a separate substrate as a separate developer or copy sheet. However, such cooling means are adapted for a copying machine using self-contained type imaging sheets wherein an encapsulated chromogenic material or dye precursor and a developer material are co-deposited on one surface of the single substrate as one layer or as two contiguous layers. The self-contained type recording medium is disclosed in U.S. Patent No. 4,440,846 and the transfer type recording medium is disclosed in U.S. Patent 4,399,209. It goes without saying that the embodiment shown in Fig. 4 is also available for cooling the transfer type recording medium.

Next, an apparatus for lowering humidity of the developer sheet will be described. The humidity controlling apparatus is required in case where the developer sheet is used at a high humidity ambient atmosphere. Incidentally, the copying apparatus used herein is different from that shown in Figs. 1 thru 4 in terms of the arrangements of the light source for light exposure, the pressure rollers, thermal image fixing rollers, and the cartridge of the sensitive sheet, and supplying position of the developer sheets.

According to a fourth embodiment shown in Fig. 5, an inlet 40 for inserting an original is formed at one side (right side in Fig. 5) of the apparatus, and a developer sheet outlet 42 is formed at an upper portion of the other side (left side in Fig. 5) of the apparatus. Further, a developer sheet inlet 43 is formed at a lower end portion of the other side.

Inside the apparatus, a photo sensitive and pressure sensitive sheet roll cassette 44 is disposed at an upper right side portion. In the cassette 44, the sensitive sheet roll P is accommodated. A feed roller 46a is disposed below the sheet roll cassette 44.. The sensitive sheet P is then conveyed toward left, and is guided by a feed roller 46b. After the sheet passes through the feed rollers 46a and 46b, the sheet is directed toward a take up roller 48 through pressure rollers 47, and is wound around the take-up roller 48. Above a part of the sensitive sheet, extending between the feed rollers 46a and 46b, there is provided a pressure plate 49 connected to a drive motor (not shown). The pressure plate 49 is vertically movable by the drive motor. Further, an original support stand 50 and an exposure stand 51 are provided at a position below the sensitive sheet P. The original support stand 50 supporting an original G therein is supplied from the original feed inlet 40, so that the original G is supported under pressure between the original support stand 50 and the pressure plate 49 when the latter is at its descent position. The exposure stand 51 is provided with exposure glass 52, and transfers the original support stand 50 mounted thereon to a predetermined position.

A diffusion plate 53 is disposed below the exposure stand 51, and a halogen lamp 54 and a reflection mirror 55 are provided at lower left side portion of the copying apparatus. Between the halogen lamp 54 and the diffusion plate 53, there is provided a color filter 56.

At downstream side of the pressure rollers 47, a thermal image fixing unit 62 is disposed for heating the developer sheet so as to perform image fixing at the developer sheet. The image fixing unit 62 includes a rubber roller 63 and a heat roller 64. Below the thermal image fixing unit 62, a fan 57 is provided for directing ambient air downwardly. The developer sheet inlet 43 is connected with a sheet guide member 58 extending rightwardly. The guide member 58 has an upper portion formed with a plurality of vent holes 59 for introducing therethrough the air from the fan 57 toward a surface of the developer sheet 12 passing through the guide member 58. The developer sheet 12 is supplied from outside of the copying apparatus thereinto through the inlet 43 and is directed toward the pressure rollers 47 by the guide member 58. An upper guide member 61 extends between the pressure rollers 47 and the thermal image fixing unit 62, so that the developer sheet 12 can be travelled to the image fixing unit 62 through the pressure rollers 47. After the developer sheet 12 has passed through the fixing unit 62, the sheet 12 is discharged outside through the outlet port 42.

An operation according to this embodiment shown in Fig. 5 will be described.

The original support stand 50 in which the original G is set at a predetermined position is inserted through the inlet port 40, and is stopped at a predetermined position. Further, the developer sheet 12 supplied through the developer sheet inlet port 43 is set at its predetermined position. In this case, the fan 57 is operated to flow air toward the developer sheet surface through the vent holes 59. This air is discharged toward outside through the developer sheet inlet port 43.

When an exposure switch (not shown) is manually depressed, the pressure plate 49 is moved to its descent position by the energization of the drive motor (not shown). Therefore, the sensitive sheet P and the original support stand 50 are brought into pressure contact with the exposure stand 52. Then, light exposure is initiated. That is, the halogen lamp 54 is lighted up, and the light is reflected at the reflection mirror and reached to the diffusion plate 53 through the filter 56. The light subjected to color conversion at the filter 56 is reflected at the diffusion plate 53 and is directed toward the glass portion 52 of the exposure stand 51. The light passes through the glass portion 52, so that an image information of the original is recorded onto the sensitive sheet P. During these steps, the fan 57 is continuously rotated for ventilation of air in the thermal image fixing unit 62, while the warm air in the image fixing unit 62 is continuously applied to the developer sheet 12 through the vent holes 59. Further, the warm air is discharged toward outside from the developer sheet inlet 43 through the developer sheet guide 58.

In this operation, entire part of the developer sheet 12 in facial contact with the sensitive sheet P on which the image is recorded is heated by the warm air. Therefore, humidity of the developer sheet 12 becomes lowered. Generally, the thermal image fixing rollers 63 and 64 have a high temperature, for example not less than 100°C, and therefore, the developer sheet 12 is efficiently heated by making use of the heat of the image fixing rollers.

Upon completion of the light exposure, the pressure plate 49 is moved to its ascent position for releasing pressure application to the sensitive sheet P. Thereafter, the take-up roller 48 and the pressure rollers 47 are rotated about their axes for feeding the sensitive sheet P. Simultaneously, the developer sheet 12 is also supplied toward the pressure rollers, and is brought into facial contact with the sensitive sheet P at a position immediately upstream side of the pressure rollers 47. These sheets overlapping with each other pass through the pressure rollers 47 under pressure, to thereby perform image transfer from the sensitive sheet P to the developer sheet 12. The used sensitive sheet P is separated from the developer sheet 12, and is taken-up by the take-up roller 48. On the other hand, the developer sheet 12 passes through the upper guide 61 and is then introduced into the thermal image fixing unit 62. Here, the developer sheet 12 is heated by the heat roller 64 for image fixing, and thereafter the sheet 12 is discharged toward outside through the sheet outlet port 42.

In order to reduce humidity of the developer sheet 12, other modifications are conceivable as shown in Figs. 6 and 7. According to a fifth embodiment shown in Fig. 6, no fan is provided. Instead, a thermal fixing unit 70 is disposed immediately adjacent to the vent holes 59 of the guide member 58 so as to directly utilize the heat ambient to the fixing unit 70. As a result, the developer sheet in the guide member 58 is directly heated by the ambient warm atmosphere.

Further, according to a sixth embodiment shown in Fig. 7, a heat transmittive roller 82 is disposed at a lower portion of the thermal image fixing unit 80, and a developer sheet feed roller 83 is rotatably disposed below the heat transmittive roller 82. The heat transmittive roller 82 is in surface rotational contact with the lower roller 81 of the unit 80, and therefore, constant heat in the unit 80 is conducted to the heat transmittive roller 82. When the developer sheet 12 passes through the rollers 82 and 83, this constant heat is transmitted to the developer sheet 12 through the heat transmittive roller 82, so that humidity of the sheet 12 can be reduced.

In view of the foregoing, if the heat of the thermal image fixing roller is utilized, it is unnecessary to provide particular heating means for heating the developer sheet 12, so that economical apparatus results. Further, since the thermal image fixing roller is subjected to heating temperature control, stabilized humidity control to the developer sheet 12 is attainable. This humidity control can effectively prevent the developer sheet 12 from sticking onto the thermal image fixing roller.

Relative humidity of the developer sheet can be lowered by using a heat generated by a halogen lamp which is employed for light exposure. To be more specific, according to a seventh embodiment shown in Fig. 8, a lower wall of the developer sheet guide 58 is formed with a plurality of vent holes 100, and a fan 101 for cooling the halogen lamp 54 disposed in confrontation with the vent holes 100 and at a position between the lower wall and the lamp. The fan 101 positively cools the halogen lamp 54, and directs warm ambient air around the lamp toward inside the guide member 58 and toward the developer sheet inlet port 43. Therefore, the developer sheet 12 passing through the guide member 58 is heated, so that moisture or water content contained therein can be removed.

Alternatively, according to an eighth embodiment shown in Fig. 9, an upper portion 110 of the light reflection member 55 largely extends along the path of the developer sheet 12, so that the upper portion is upwardly bent. The upwardly bent portion 110 of the reflection member 55 serves as a lower guide member for guiding the travel of the developer sheet 12. Therefore, when the developer sheet passes over the upwardly bent portion 110 of the light reflection member 55, the developer sheet 12 is heated thereby, to thus remove moisture of the sheet.

A ninth embodiment is shown in Figs. 10 and 11 which utilizes heat of a halogen lamp serving as the light source. As shown in Fig. 10, a heat collecting sleeve 700 extends in vertical direction and is positioned above a halogen lamp 54. An upper end of the sleeve 700 is fitted with a heat accumulating and emitting block 701 made of aluminum. Radiation heat from the light source 54 is partially entered into the heat collecting sleeve 700 through its lower open end 700b, and the heat is accumulated in the block 701. The upper surface of the heat emitting block 701 is in contact with the developer sheet 12, and therefore, the developer sheet 12 is heated during its slide contact with the upper surface.

As shown in Fig. 11, a lever 702 is pivotally suspended from a side wall of the heat accumulating and emitting block 701 by a pivot pin 703, and a supporting projection 704 is secured to the side wall of the block 701. Further, a spirally wound bimetal 705 is provided over the pivot pin 703. The spiral bimetal 705 is secured between the support projection 704 and a base end portion of the lever 702. A shutter 706 is supported to one side portion of the heat collecting sleeve 700. The shutter 706 is projectable and retractable with respect to a hollow space of the sleeve 700. A lower end of the lever 702 is formed with a guide slot 702a, and a base portion of the shutter 706 is provided with a guide pin 706a engageable with the guide slot 702a. Since aluminum which is a material of the heat accumulating and emitting block 701 has sufficient heat capacity and heat conductivity, radiation heat from the light source 54 is efficiently accumulated in the block 701. Therefore, sufficient heat energy is promptly accumulated in the block 701, and the block 701 rapidly provides a temperature capable of heating the developer sheet 12.

The bimetal 705 changes its shape in response to the temperature of the heat accumulating and emitting block 701. Because of the shape change of the bimetal 705, the lever 702 is pivoted about the pivot pin 703 so as to control projecting length of the shutter 706 with respect to the hollow space of the sleeve 700. If the temperature of the block 701 is elevated, the shutter 706 extensively moves into the heat collecting sleeve 700. On the other hand, if the temperature of the block 701 is lowered, the shutter is retracted from the hollow space of the sleeve 700. As a result, the heat accumulating and emitting block 701 provides a predetermined given temperature available for image formation and image fixing. Incidentally, instead of the bimetal 705, a shape memory alloy is also available. Further, the lever 702 can be formed of shape memory alloy with eliminating the bimetal 705.

Furthermore, other modifications are conceivable. For example, the heat accumulating and emitting member is formed of a hollow cylindrical shape having an open end at its lower portion. Further, the heat accumulating and emitting member can be formed of material other than aluminum such as copper, ceramic, etc. those having high heat capacity and heat conductivity. Furthermore, the heat accumulating and emitting member can be formed of a combiantion of two materials such as the combination of aluminum which provides high thermal capacity and copper which provides high heat transmitting coefficient.

A tenth embodiment is shown in Fig. 12, in which a developer sheet inlet port 150 is provided at a lowermost side portion of the copying machine, and a diffusion plate 151 extends up to the inlet port 150, so that the developer sheet path is initially located below the light source 54. Upper end portion of the diffusion plate 151 is positioned adjacent the pressure rollers 47, 47 so as to supply the developer sheet thereto. With this structure, the developer sheet per se running over the diffusion plate 151 serves as a light diffusion member. Simultaneously, radiant heat from the halogen lamp 54 is applied to the developer sheet 12 running over the diffusion plate 151. Therefore, humidity in the developer sheet can be lowered.

According to this embodiment, feed rollers 152, 153 and 154 are rotatably disposed alongside the diffusion plate 151 for supporting the developer sheet. During exposure step, the developer sheet 12 is heated, and the sheet is transferred to the pair of pressure rollers 47 at which the developer sheet 12 is overlapped with the sensitive sheet P supplied from a roll sheet cassette 44 for image forming. Thereafter, similar to the foregoing embodiments, the image carrying developer sheet 12 passes between the image fixing rollers 63,64 through the guide 155 and is discharged outside through an outlet port 42. Further, in this embodiment, the original support stand 50 is inserted from the left side of the machine in Fig. 12. Furthermore, the diffusion member 161 can be provided with an internal passage 160 as shown in Fig. 13 ( an eleventh the embodiment ) so as to allow the developer sheet 12 to pass therethrough. When the developer sheet 12 passes through the internal passage, the sheet 12 undergoes heat radiation from the diffusion member 161.

An twelfth embodiment according to this invention is shown in Fig. 14 in which the developer sheet 12 is directly heated by the heat of the halogen lamp 160. That is, the halogen lamp 160 is positioned at the lowermost portion of the copying machine, and is secured to a lower bottom portion of a conical shaped diffusion plate 161. A lower light exposure glass 162 is provided at a position above the conical diffusion plate 161, and an upper light exposure glass 163 is positioned above the lower light exposure glass 162. The developer sheet 12 is travelled through a space defined between the upper and lower exposure glasses 163 and 162 with the guidance by feed rollers 165 and 166. An original support stand 50 is positioned above the upper light exposure glass 163, and further, a pressure plate 49 is disposed over the original support stand 50.

The developer sheet 12 is inserted through an inlet port 169 formed at right side portion in the drawing, and the original support stand 50 is inserted through an insertion hole 170 at the right side portion and above the inlet port 169.

With this structure, the developer sheet 12 is inserted through the inlet port 169 and is stopped at a predetermined position after feeding by the feed rollers 166, 168. Then, light exposure is initiated by the halogen lamp 160, so that the light emitted from the lamp 160 passes through the developer sheet 12 and is reached to the sensitive sheet P extending between the original support stand 50 and the pressure plate 49. In this instance, the sensitive sheet P is exposed, while the developer sheet 12 is heated for a predetermined period by radiant heat from the halogen lamp 160. Upon completion of the light exposure, the sensitive sheet P and the heated developer sheet 12 are synchronously supplied to the pressure rollers 47, 47 for image forming. Thereafter, the image carrying developer sheet 12 passes through the fixing rollers 63,64 in the image fixing unit, and is discharged outside.

A thirteenth embodiment of this invention is shown in Fig. 15, wherein overall arrangement is substantially the same as that in the embodiment shown in Fig. 8 except provision of the fan 101 in Fig. 8. Instead, the embodiment shown in FIG.15 is provided with a shielding plate 180 having an upper end pivotally supported to the base frame. The shielding plate 180 is angularly movable by 90 degrees as shown by solid and broken lines in Fig. 15 in response to a heat sensitive sensor (not shown) or shape change of a shape memory alloy. To be more specific, if ambient temperature around the halogen lamp 54 is relatively low because of initial start-up period of the copying machine, the shielding plate 180 is at a position shown by the solid line in Fig. 15. Accordingly, heat directing toward the diffusion plate 53 is blocked by the shielding plate. In this case, warm air in a halogen lamp chamber 181 is introduced into the developer sheet guide 58 through vent holes 183 formed in the lower guide plate so as to heat the developer sheet 12 passing through the guide 58. If the temperature in the halogen lamp chamber 181 exceeds a predetermined temperature, the shielding member 180 is pivotally moved to a position shown by the broken line in Fig. 15. Therefore, warm air supply to the guide member 58 is blocked by the shielding plate 180 and light exposure to the sensitive sheet is initiated, since the light can be directed to the diffusion plate 53 without any obstacle by the shielding plate 180.

A fourteenth embodiment is shown in Fig. 16 for controlling temperature of warm air directed toward the developer sheet 12. In the another embodiment shown in Fig. 16, an axisymmetric flow fan 200 is provided at one side of the halogen lamp chamber 181 for cooling the ambient atmosphere around the halogen lamp 54. On the other hand, a developer sheet guide 58 is disposed above the halogen lamp 54. An intermediate portion of the guide member 58 is formed with a semi-circular recess 205 in which a lower feed roller 207 is rotatably accommodated. A stepped portion 208 is formed at the recess 205 so as to temporarily stop the travel of the developer sheet 12. The lower feed roller 207 is connected to a swing arm 209, so that the lower feed roller 207 is movable toward and away from the upper feed roller 206 by pivotal movement of the swing arm 209. A free end portion of the guide member 58 extends toward the pressure rollers 47, and a vent hole 201 is formed in the free end portion. Below the vent hole 201, there is provided a flow restricter 210 extending in horizontal direction and movable from one side to another of the base frame. One end (left side in Fig. 16) of the flow restricter 210 is connected to a coil spring 204 formed of shape memory alloy, and is supported to a fixed member 211, while another end (right side in Fig. 16) of the restricter 210 is supported to a fixed member 212 through a coil spring 204. The flow restricter 210 includes an opening portion 203 at one side and a closure portion at the other side. When the opening portion 203 is at a position shown by a solid line in Fig. 16, hot wind from the fan 200 can be directed toward developer sheet 12 in the guide member 58 through the opening portion 203 and the vent holes 201. The hot air is discharged through the developer sheet inlet port 43. On other other hand, when the flow restricter 210 is at a position shown by broken line in Fig. 16 because of the contraction of the spring 204, the closure portion 213 blocks a hot air passage 214 defined between the lower face of the recessed portion 205 and the upper surface of a casing of the filter 56. As a result, hot air introduction into the developer sheet 12 is prevented.

In operation, at an immediate time after the power supply to the copying machine, or at a phase where the pressure rollers 47 are not sufficiently heated, the shape memory coil spring 202 is stretched by the other coil spring 204, so that the hot air passage 214 is in fluid communication with the internal space of the guide member 58. Therefore, hot air given by the heat of the halogen lamp 54 can be supplied, through the vent holes 201, to the developer sheet whose leading end is in abutment with the stepped portion 208. After the continuous light exposure, ambient temperature of the halogen lamp 54 is elevated, and the shape memory coil spring 202 is contracted in response to the elevated temperature before the temperature required at the image forming at the pressure rollers exceeds a predetermined level. As a result, the hot air passage 214 is blocked by the closure portion of the flow restricter 210, so that excessive temperature increase at the image forming step can be obviated. In the above embodiments for heating the developer sheet 12 in order to reduce humidity thereof, heat at the thermal image fixing unit or heat at the light source is utilized. However, in the following embodiment, another heating unit is disposed for heating the developer sheet 12.

According to a fifteenth embodiment shown in Fig. 17, a developer sheet guide member 58 extends from the developer sheet inlet 43 similar to the foregoing embodiments. However, at an intermediate portion of the guide member 58, an auxiliary guide portion 90 is provided which is formed of heat conductive material. The auxiliary guide portion 90 includes a pair of guide plates 91 and 92 (upper and lower guide plates) each formed with a semi-circular recess 91a and 92a. In the upper and lower recesses 91a and 92a, a heat roller 93 and a feed roller 94 are rotatably disposed, respectively. A heater 93a is accommodated in the heat roller 93. The feed roller 94 is vertically movably supported by an arm 95 pivotably supported to a main frame, so that the feed roller 94 is moved toward and away from the heat roller 93 by the pivotal movement of the arm 95.

Upon heat generation at the heater element 93a, the heat roller 93 and neighbouring heat conductive guide plates 91 and 92 are heated. Therefore, the developer sheet 12 is heated upon passing through the guide plates 91,92 and the rollers 93 and 94, which heating location is positioned at upstream side of the pressure rollers 47, to thus reduce humidity of the developer sheet 12.

According to a sixteenth embodiment shown in Fig. 18, a supplemental developer sheet guide portion 100 is provided at an intermediate portion of the guide member 58. The supplemental guide portion 100 is made of heat conductive material, and includesss an upper and lower guide members 101 and 102 formed with semi-circular recesses 106 and 107, respectively. Upper and lower feed rollers 103 and 104 are rotatably accommodated in the recesses 106 and 107, respectively. The lower feed roller 104 is connected to a swing arm 105, so that it moves toward and away from the upper feed roller 103 upon swinging movement of the swing arm 105. The guide members 101 and 102 respectively provide rod heaters 108 and 109. Heat generated at the rod heaters 108, 109 is transmitted to the developer sheet through the inner surface of the guide members 101, 102 and the feed rollers 103,104.

A seventeenth embodiment is shown in Fig. 19 in which two opposing guide members 121 and 122 are provided for guiding the developer sheet 12 in upward direction. The guide members 121 and 122 are formed of plate like heat generating members. At an intermediate portion of the guide members, feed rollers 123 and 124 are provided. Further, a kick-out roller 126 is provided above a developer sheet stacking case (cassette) 125 so as to supply each developer sheet into the guide members. The developer sheet 12 supplied into the guide members 121 and 122 by the kick-out roller (sheet feed roller) 126 is moved toward pressure rollers 127,128 of a pressure unit 120 by the rotations of the feed rollers 123 and 124. During this travel, the developer sheet is heated by the heat generating plates, i.e., the guide members 121 and 122.

An eighteenth embodiment is shown in Figs. 20 and 21. In the foregoing embodiments, curved guide members are used for guiding travel of the developer sheet 12. On the other hand, in this modified embodiment, a developer sheet feeding table 130 is provided. The feeding table 130 includes a flat plate heat radiation portion 131 which generates heat upon supply of electrical current, a suspension portion 132 suspended from the central portion of the lower surface of the heat radiation plate 131, and a connecting portion 133 fixed to the suspension portion 132. The suspension portion is fixedly supported on a base plate 134. A feed roller 135 is disposed over the flat heat generating plate 131 for interposing the developer sheet therebetween. When the sheet passes over the heat radiation portion 131, the developer sheet is heated.

Humidity of the developer sheets is also controllable in association with a sheet cassette which stores the developer sheets. Various embodiments with respect to the humidity control in conjunction with the sheet cassette will next be described in detail.

Referring first to a nineteenth embodiment shown in Fig. 22, a sensitive sheet roll 251 is disposed at an upper portion in an interior of a main frame 250. The sheet roll 251 is accommodated in a sheet roll cartridge 252. An exposure station 253 is positioned below the sheet roll cartridge 252. An original 256 mounted on an original support stand 255 is irradiated by a light source 254, and the light reflected at the original support stand is directed to the sensitive sheet P through a lens 257 and mirrors 258, 259 for forming a latent image on the sensitive sheet P. At a lower left portion of the cartridge 252, a pressure unit 260 is provided at which the latent image carrying sensitive sheet P and a developer sheet 12 are overlapped with each other, and these are pressed. As a result, chromogenic material in the microcapsules which have been not exposed with light at the exposure station flows out upon rupture of the microcapsules carried on the sensitive sheet P, and the chromogenic material is reacted with the developer material of the developer sheet to thereby provide coloring image on the developer sheet. The sensitive sheet P is taken-up by a take-up roll 262. Further, a thermal image fixing unit 261 is positioned adjacent the pressure unit 260. Color image appearing on the developer sheet is fixedely held to the sheet and gloss picture image is obtainable thereon at the image fixing unit 261. Thereafter, the developer sheet 12 is discharged to a receptacle member 263.

The developer sheet 12 is originally stored in a sheet cassette 264 which is obliquely and detachably disposed in the main frame 250. The sheet cassette 264 is inserted through a casette insertion hole 265 as shown Figs. 23 and 24 at which a shutter 266 biased by a spring is provided. A sheet feed roller 270 is provided over the cassette 264 to feed one by one developer sheet 12 toward the pressure unit 260. The developer sheet 12 is discharged out of a discharge port 267 and stacked over a receptacle 263. At the discharge port 267, a shutter 268 is disposed which is operable in response to an electromagnetic solenoid (not shown). Further, below the discharge port 267, a moisture absorbing agent 269 (hygroscopic material) is provided and a heat source h is provided.

In operation, during operable state of the copying machine, the shutter 268 is opened inwardly by the actuation of the electromagnetic solenoid so as to allow image fixed developer sheet 12 to pass through the discharge port 267 and to be transferred onto the receptacle 263. The heat source h heats the moisture absorbing agent 269, so that dry air whose moisture content is removed at the moisture absorbing agent is discharged outside through the shutter 268. In non-service period of the copying machine, the shutter 268 is closed to block fluid communication with the outside. When the developer sheet cassette 264 is removed from the copying machine, the shutter 266 is also closed by the biasing force of the spring for blocking fluid communication with the outside. On the other hand, when the sheet cassette 264 is inserted, the shutter 266 is opened. In this case, since the cassette insertion hole 265 is closed by the cassette 264, external air cannot be entered into the interior of the machine.

In non-service period of the copying machine, moisture in the machine can be effectively absorbed by the moisture absorbing agent, since completely confined or fluid-tight machine interior is obtainable by closing the shutters. The moisture absorbed in the agent can be discharged outside during operation of the copying machine.

With this structure, humidity in the interior of the machine becomes lower than the external humidity to thus prevents the sheet from sticking onto the pressure and image fixing units even if the ambient humidity is relatively high.

In a twentieth embodiment with respect to the sheet cassette as shown in Figs. 25 and 26, a push-up plate 280 is provided to the sheet cassette 264. The push-up plate 280 is urged upwardly by a spring (not shown). At the overall surface of the push-up plate, a heater 281 is provided, and terminals 282, 282 of the heater 281 are provided at an outer wall surface of the cassette 264. Further, electrical terminals 283 and 283 are provided at both lateral sides of the cassette insertion hole 265. When the sheet cassette 264 is inserted into the cassette insertion hole 265, the terminals 282,282 are brought into contact with the terminals 283, 283, so that an electrical current is applied to the heater element 281. When the heater 281 is heated upon application of the electrical current, the developer sheets 12 stacked on the cassette 264 are heated by the heater to thus remove moisture in the developer sheets. Incidentally, a temperature/humidity sensor 284 is provided to control heating temperature of the heater element 281.

Further, the feed roller 270 for feeding the developer sheet 12 to the pressure unit can be provided with a heating element 285 in a hollow space thereof as shown in Fig. 26 (twenty-first embodiment), such that the roller 270 serves as a heat roller. Upon contact of the heat roller 270 with the uppermost developer sheet on the sheet cassette 264, the sheet is heated.

Furthermore, in order to heat the developer sheets 12 stored in the sheet cassette 264, the sheet cassette 264 is completely confined within the main frame 250 so as to render the cassette to be separeted from the external atmosphere as shown in FIG.27(twenty-second embodiment). And, a fan 290 is provided at a position adjacent the thermal fixing unit 261 for directing a hot ambient air toward the uppermost sheet 12 by the rotation of the fan 290.

The developer sheets stored in the sheet cassette 264 can also be dryed by providing a sheet like drying agent or desiccant at an upper portion of the cassette 264 as shown in Figs. 28 thru 31(twenty-third embodiment).

In this embodiment, the upper portion of the cassette 264 is covered with a sheet-like drying member 300 whose rear end is detachably supported by a support member 301 which is pivotably supported to the sheet cassette 264. A free front end of the sheet-like drying member 300 is formed with cut-away portions 302, 302 into which the sheet feed rollers 270 and 270 are positioned. Therefore, the sheet-like drying member 300 does not interface the rotational motion of the sheet feed rollers 270 as best shown in Figs. 32 and 33.

As shown in Fig. 34, the sheet-like drying member 300 includes a base substrate 310, minute powders of silica gel 312 and adhesives 311 for bonding the silica gel onto the substrate. The base substrate is formed of a material selected from ordinary paper, polyethylene film, polyimide film and cloth. The adhesive is made of glue or polyvinyl alcohol. The silica gel (SiO₂·nH₂O) has a particle size ranging from several micrometers to several hundred micrometers. Part of each silia gel is exposed out of the adhesives.

Alternatively, as shown in Figs. 35 and 36, the sheet-like drying member 300 includes a fibrous porous base substrate 313, silica gel powders 312 dispersed in the voids of the fibrous base substrate and a gas permeable sheets 314 sandwitching the combination of the base substrate 313 and the silica gels 312. Incidentally, in the embodiment shown in Fig. 31, relatively thick sheet-like drying member 300 is employed in which the silica gels 312 are attached to the base substrate.

The above described sheet-like drying member 300 can minimize a developer sheet area in contact with the external atmosphere, since the member 300 confines the sheets in the sheet cassette 264, to thereby further reduce humidity of the developer sheet 12. If the drying member absorbs a predetermined amount of water or moisture, its moisture removing efficiency will be lowered. In this connection, the drying member 300 itself is subjected to drying by heating the same by the heat of the image fixing unit 261 during its travel along the developer sheet path in response to an actuation of an external switch or by manual operation.

If the thickness of the drying member 300 is larger than the total thckess of the sensitive sheet P and the developer sheet 12, the drying member 300 cannot smoothly pass through the pressure unit 260. Therefore, the distance between the confronting pressure rollers is increased in synchronization with the actuation of the external switch. The sheet-like drying member 300 undergoing drying at the image fixing unit 261 is discharged to the sheet receptacle tray 263, and again, the drying member 300 is attached to the developer sheet cassette 264 as shown in Fig.28.

Alternatively, as shown in Fig. 28, each of the rollers disposed alongside the developer sheet path are reversely rotated in order to return the drying member back to the sheet cassette 264, after a paper sensor 310 disposed adjacent the thermal image fixing unit 261 detects the passing of the drying member 300 through the unit 261.

In a twenty-fourth embodiment shown in Fig. 37, the sheet-like drying plate 300 is placed on a hold member 310 obliquely provided above the supply roller 270. The sheet-like drying member 300 is dryed by the thermal image fixing unit 261 in the similar fashion as described above. In this embodiment, the drying member 300 is introduced into the main frame either from a drying member insertion hole 271 disposed above the cassette insertion hole 265. The drying member 300 is adapted to absorb moisture at the position on the hold plate 310. The drying plate 300 can be moved through the pressure unit 260 and the image fixing unit 261 and is discharged onto the discharge tray 263. Alternatively, an additional drying member transferring passage 311 is provided which is branched at immediately downstream side of the image fixing unit 261 so as to direct the drying member 300 which is dryed at the image fixing unit 261 toward the hold plate 310. Ambient moisture within the main frame is removed by the drying member 300 disposed on the hold plate 310.

In a twenty-fifth embodiment shown in Fig. 38, a heater unit 320 is provided for heating exclusively the drying member 300. The heater unit 320 is positioned at the path of developer sheet 12 within the main frame, and is normally at its OFF state. The drying member 300 is occasionally supplied into the heater unit 320 which is occasionally switched to ON state to heat the drying member 300. By the reversal rotation of the feed roller 321, the drying member 300 is returned back to the upper portion of the developer sheet cassette 264 for absorbing moisture in the cassette.

The above embodiments employ drying member or sheet for lowering humidity of the developer sheets or of the ambient atmosphere. If a closed type cassette is intended to be used as shown in Figs. 39 and 40, the following arrangements are also conceivable.

According to a twenty-sixth embodiment shown in Fig. 39, a developer sheet roll 321 is used. The sheet roll 321 is accommodated in a sheet roll cassette 320. A continuous web-like developer sheet 321 is unwound by the rotation of developer sheet feed rollers 322 supported to the maim frame. The developer sheet web 321 is transferred to a predetermined path provided within the main frame. The sheet roll cassette 320 is formed with an outlet port 324 at which a pair of sealing rollers 325 are provided. The two sealing rollers 325 are urged toward each other by a spring 326, so that developer sheet web 321 is pressed by the sealing rollers 325 during its travel therethrough. Further, within the cassette 320, drying agent 327 is provided. This drying agent 327 absorbs moisture within the cassette casing 320 if the moisture is increased due to the increase in external humidity. Therefore, constant humidity is provided within the cassette 320. Further, the sealing rollers 325 serve to minimize entry of the external atmosphere into the cassette 320.

In a twenty-seventh embodiment shown in Fig. 40, cut developer sheets 12 are stored in a sheet cassette 330. Each one of the cut sheets 12 is successively fed out by feed rollers 331 disposed within the cassette 330. Similar to the embodiment shown in Fig. 39, a pair of sealing rollers 325 are provided at a developer sheet outlet 332, and the rollers 325 are biased toward each other by a spring 326, and a drying agent 327 is provided at an upper inner surface of the cassette 330.

Not only the developer sheet but also the sensitive sheet (photo sensitive and pressure sensitive sheet P) should undergo moisture removal. Therefore, various embodiments will be given for removing moisture of the sensitive sheet P.

In a twenty-eighth embodiment shown in Figs. 41 and 42, a web-like sensitive sheet roll 341 is accommodated in a sensitive sheet roll cassette 340 which provides an outlet passage 342 at one side portion thereof for permitting the sensitive sheet P to pass therethrough. At an outlet end of the outlet passage 342, disposed is a shielding member 343 which is biased by a spring 343a for providing air-tight structure in the cassette 340. The shielding member 343 has one end pivotally supported to the sheet roll cassette 340 by a pin 343b. This biasing force of the spring 343a, however, does not restrain smooth travel of the sensitive sheet P without damage to the same. Other type of shielding member is also available. For example, the shielding member 343 is formed with a memory shape alloy or bimetal. If heated, the shielding member chages its shape to open the passage 342. Alternatively, a heating means is provided at the image forming zone. At the time of image forming on the sensitive sheet P, the heating means heat the shielding member 343. With the alternative arrangement, similar effect is obtainable.

Since the interior of the sheet roll cassette 340 is separated from outside because of the shielding member 343, light and moisture are not entered into the sheet roll cassette 340. Therefore, the sensitive sheet P is not affected thereby. Further, since a moisture absorbing agent 344 is provided in the cassette 340, and accordingly, low humidity is maintainable within the cassette 340. Silica gel is used as the moisture absorbing agent 344.

In a twenty-ninth embodiment shown in Fig. 43, a moisture absorbing agent 344 is attached to the external portion of the sensitive sheet roll cassette 340. That is, the cassette 340 is provided with an open recess 340a into which the absorbing agent 344 is disposed. When the sheet cassette 340 is assembled in the copying machine, the moisture absorbing agent 344 absorbs ambient moisture around the image forming unit such as pressure rollers, thereby to obtain stabilized picture image. If the sheet roll cassette 340 is intended to be exchanged by a new one, the moisture absorbing agent 344 can also be exchanged easily.

In order to dry an interior space of the sensitive sheet cassette, hot air is blown into the interior space of a cassette 500 as shown in Figs. 44 to 46. In a thirtieth embodiment shown in Fig. 44, a sensitive sheet P wound around a supply roll 501 is drawn out and wound over a take-up roller intermittently rotated by a drive means (not shown ). The sheet P is fed to an image exposure region below a halogen lamp 502. In the exposure region, light transmitted through the original 503 is irradiated to the sensitive sheet P. In this embodiment, a halogen lamp chamber is communicated with the cassette 500, so that hot air in the halogen lamp chamber is introduced into the cassette chamber.

In an embodiment shown in Figs. 45 and 46, a blower 514 is provided at one side of a halogen lamp 502. An aspiration port 514a of the blower 514 is positioned in confrontation with the halogen lamp 502. Further, a hot air discharge port 514b is directed toward a side wall of the sheet cassette 500.

As shown in Figs. 45 and 46, the sensitive sheet roll cassette 500 includes a housing 515 having a rectangular cross-section. The housing 515 is formed with a slot for passing the sensitive sheet therethrough. Open ends of the rectangular housing 515 are closed by cover members 516 and 517, and a sheet roll core member 518 is rotatably supported by holes formed at central portions of the cover members 516, 517. The web-like sensitive sheet P is wound around the core member 518. Both axial ends of the core member 518 are integrally provided with flanges 518a and 518b, and annular ribs 518c and 518d extend from the outer peripheal end portions of flanges in axial direction of the core members 518 and toward the cover members 516,517. Planar ends of the ribs 518c and 518d are slightly spaced away from the flanges 518a, 518b, respectively, as best shown in Fig. 46. One of the cover members 516 is formed with a hot air inlet port 516a in alignment with the hot air discharge port 514b and at a position within an area of the flange member 518a. At an inner side of the cover member 516, a light shielding member 516b is provided so as to optically block the hot air discharge port 514b. In the cassettte 500, the hot air inlet port 516a is oriented toward a central axis of the roll core member 518. In other words, the light shielding member 516b also serves as a hot air deflector.

In the other cover member 517, four discharge ports 517a are formed at equi-distance in circumferential direction and within an area of the opposing flange 518b. Inside the cover member 517, light shielding members 517b are provided to optically shield the discharge ports similar to the light shield member 516b.

By the operation of the blower 514, hot air around the hologen lamp 502 is aspirated from the aspiration port 514a, and is discharged into the interior of the cassette 500 through the discharge port 514b and the inlet port 516a. The hot air flows through a space defined between the cover mnember 516 and the flange 518a, and a space defined between the sheet roll 501 and the housing 515 as indicated by arrows in Fig. 46. By these hot air flow, the sheet roll 501 is heated, and the air is discharged out of the discharge ports 517a. Since the hot air flows within the housing 515 in an axial direction of the roll core member 518, the sensitive sheet roll 501 is efficiently heated, and therefore, the temperature of the roll 501 promptly elevated to a predetermined temperature. Accordingly, the sensitive sheet P can be subjected to light exposure immediately after the sheet P is taken out of the cassette 500, since the sheet P provides a predetermined elevated temperature. As a result, microcapsules on the sheet P are well photo-cured regardless of ambient temperature.

A dust collecting filter (not shown) can be provided at the aspiration port 514a of the blower 514. The dust collecting filter can prevent dusts from entering the cassette 500 (light shielding case), and sticking of the dusts to the sensitive sheet P is obviated, which sticking may degrade photo sensitivity of the sheet.

Hot air passage is deflected at both axial end portions of the core member by the light shielding member 516b, the ribs 518c and 518d and the light shielding members 517a. Any light entered into the hot air inlet port 516a and the discharge ports 517a can be blocked by the shielding members. Therefore, the sensitive sheet P within the cassette 500 is not exposed with light at all.

In a modified embodyment which uses a blower, a hot air temperature control unit 519 is provided between the aspiration port 514a and the air discharge port 514b to provide a given hot air temperature (Fig.47). In the temperature control unit 519, a heater and a thermostat are assembled. The heater is ON-OFF controlled by a switch 520, and the thermostat is controlled by a control knob 521 within ON-OFF range. With this arrangement, temperature within the sensitive sheet roll cassette 500 can be precisely controlled (much heated or cooled ), to thereby perform fine temperature control to the sensitive sheet P.

In the embodiments shown in Figs. 45 to 47, an inner hollow space of the roll core member 518 can be communicated with the hot air passage defined bewtween the covers 516,517 and the flanges 518a, 518b so as to introduce hot air into the inner hollow space of the core member 518. Alternatively, the core member 518 can be formed of porous material such as sponge or of a material having a high heat conducting efficiency. By such arrangement, sheet roll 501 within the cassette 500 can be further heated.

Further, a humidity control unit can be assembled into the temperature control unit 519. Furthermore, such embodiments shown in Figs. 44 to 47 can be applied to the case where cut sensitive sheets P are stored in the sheet cassette.

A thirty-first embodiment for drying the sensitive sheet is provided in Fig. 48. In the embodiment of Fig. 48, a sensitive sheet roll 351 and a take-up roll 352 are disposed at an upper internal portion of a main frame 350. A sensitive sheet P wound around the roll 351 is oriented in horizontal direction by a feed roll 353, so that the sheet P passes over a original stand 354. The light source 355 is positioned below the original support stand 354. The sheet P passing through the stand 354 is taken-up by the take-up roller 352 through the pressure and fixing rollers 356, 356. A developer sheet 12 is also fed to the pressure rollers 356, 356 by a guide roll 357, so that both sheets P and 12 are overlapped with each other and pressed by the pressure and fixing rollers. The developer sheet 12 on which an image is transferred is discharged out of the main frame 350 by feed rollers 358.

The above-described feed roller 353 is a heat roller in which a heating element 353a is accommodated. The sensitive sheet P is heated and dryed when it passes through the heat roller 353.

According to a thirty-second embodiment shown in Fig. 49, a fan 360 is provided at an upper internal space of a main frame 350. Hot air generated by a light source 355 and floating at the upper internal portion of the frame 350 can be agitated and dispersed by the rotation of the fan 360. Therefore, the sensitive sheet P as well as the developer sheet 12 are dryed.

Further, in a thirty-third modification shown in Fig. 50, a heater 361 is provided at a position immediately above a fan 360. Air heated by the heater is distributed by the fan. Furthermore, in a thirty-fourth modification shown in Fig. 51, a heater 362 is provided at lower internal space of the main frame 350 for locally heating the lower internal portion of the space, which lower space has a temperature generally lower than the upper internal space unless the heater 362 is provided. As a result, the sheet P and the developer sheet 12 are dryed.

Furthermore, in a thirty-fifth modification shown in Fig. 52, pressure and image fixing rollers 356 and 356 are located at an upper internal portion of a main frame 350. With this arrangement, since hot air is floated at the upper portion, the sensitive sheet P and the developer sheet 12 are also pressed in the hot atmosphere. As a result, image transfer operation is achievable in a low humidity atmosphere.

Next, heating and drying to the sheets is achievable by heating overall internal space of the main frame. Such arrangement will be described with reference to Figs. 53 and 54. In a thirty-sixth embodiment shown in Fig. 53, a light source casing 370 provided with a louver 372 is provided at an upper portion and adjacent to one side wall of a main frame 250, and a fan 371 is provided at the one side wall and confronting the louver 372. Air stream generated by the fan 371 passes through the louver 372 for cooling the light source 254, whereas hot air in the light source chamber 370 can be discharged therefrom through a vent hole 373 formed at a light source chamber wall confronting the louver 372. The hot air is introduced into the interal space defined by the main frame 250. At the vent hole 373, a dust cleaner element 374 is provided so so to prevent dusts from entering into the interior of the main fram 250.

Alternatively, a fan 375 is provided at a position adjacent the thermal image fixing unit 261 so as to scatter hot air around the unit 261 toward every directions, to thus elevate temperature in the internal space of the main frame 251.

Furthermore, in a thirty-seventh embodiment shown in Fig. 54 for controlling temperature and humidity of the atmosphere within the main frame, a temperature control unit 401 is disposed at a suitable portion of the main frame 400, for example, at a position below a diffusion plate 53. The temperature control unit 401 includes a heater element 404 located below the diffusion plate 53, a sensor 402 for detecting temperature and humidity of the atmosphere, and a controller 403 for controlling the heater element 404. In this embodiment, a developer sheet cassette 405 is disposed within the main frame 400. The remaining construction would be the same as that of the embodiment shown in Fig. 5 except the fan 57 and the guide member 58 those shown in Fig. 5.

The temperature/humidity sensor 402 comprises a temperature sensor 441 and a humidity sensor 442. The temperature sensor 442 is made up of a temperature sensing element 431, such as a thermistor, and an amplifier 432, and the humidity sensor 442 is made up of a humidity sensor unit 433 and a linearlizer amplifier 434. The humidity sensor 442 detects a relative humidity in the interior of the apparatus. Voltage signals representative of the temperature and humidity which are in proportional to the temperature and humidity are outputted from the temperature sensor 441 and the humidity sensor 442, respectively, and which signals are applied to an analog multiplexer 435. From the analog multiplexer 435, either one of the temperature and humidity signals is selectively outputted and applied to an analog-to-digital (A/D) converter 436. In the A/D converter 436, the the input analog signal is converted into a digital signal and the latter signal is applied to a CPU (Central Processing Unit) 437. A control logic 443, a solid-state relay 440, ROM (Read-Only Memory) 438 are connected to the CPU 437. A control program and a conversion table giving an allowable temperature from the data of temperature and humidity have been written in the ROM 438. The allowable temperature is defined by a minimum temperature that the apparatus is usable (a condition, for example, that jamming does not occur), as the relative humidity is lowered attendant on the increase of temperature. A control signal is supplied to the control logic 443 from the CPU 437 so that the temperature and the humidity signals are alternatively outputted from the analog multiplexer 435. Based on both the temperature and the humidity signals, an allowable temperature datum is read out of the ROM 438, and the solid-state relay 440 is controlled by the data thus read out. A heater 404 is rendered conductive or non-conductive by the solid-state relay 440 thus controlled.

Referring to Fig. 56, the control of the temperature and humidity will next be described in detail. In Step 1, the CPU 437 controls the control logic 443 and instructs the analog multiplexer 435 to select the humidity signal. The signal passed through the analog multiplexer 435 is subjected to A/D conversion by the A/D converter 436, and the resultant digital signal is inputted to the CPU 437. In Step 2, the CPU 437 controls the control logic 443 and instructs the analog multiplexer 435 to select the temperature signal. The signal passed through the analog multiplexer 435 is subjected to A/D conversion by the A/D converter 436, and the resultant digital signal is inputted to the CPU 437. The CPU 437 determines the temperature and the relative humidity in the interior of the apparatus based on the signals inputted. In Step 3, the CPU 437 determines an allowable temperature based on the temperature and the relative humidity thus determined according to the conversion table written in the ROM 438. In Step 4, the CPU 437 compares the ambient temperature in the apparatus with the allowable temperature, and when the former is lower than the latter, the operation in Step 5 is performed in which the CPU 437 controls the solid-state relay 440 to cause the heater 423 to be in conductive state. When the ambient temperature is higher than the allowable temperature, the operation in Step 6 is performed in which the CPU 437 controls the solid-state relay 440 to cause the heater 423 to be in non-conductive state. Thereafter, the proceedings returns to Step 1 and the similar operations are repeatedly carried out. Accordingly, in the condition where the ambient temperature is lower than the allowable temperature, the heater 404 generates heat and thus the ambient temperature is increased to thereby lower the relative humidity.

It is possible to incorporate a cooling means such as a Peltier element 450 (Fig.55) in a temperature adjusting means. The Peltier element 450 is connected to the solid-state relay 440 through a rectifier circuit 451. When the ambient temperature in the casing is higher than the allowable temperature, the cooling element is enabled to cool the apparatus, then condense water vapor to gather water droplet in a predetermined position, and thereafter heat the ambient temperature, whereby the humidity can be lowered at a normal temperature.

The above described embodiments all concern cases where the sensitive sheet P is heated within a predetermined allowable tempreature , for example, such as not more than 35°C, and humidity is set lower than a predetermined level. On the other hand, in another aspect of the copying conditions, the pressure unit must have a temperature higher than the allowable temperature range if the copying machine is operated under severe cold condition. Further, binders are used to fixedly secure the microcapsules on the substrate of the sensitive sheet. If the binders are made of a material other than thermoplastic resin, such as, for example, thermosetting resin, the pressure unit should provide a another predetermined temperature for facilicating rupture of the microcapsules. The thermosetting resin is selected from a urea resin such as urea-formalin resin and melamine-formalin resin, a polyester group resin, an epoxy group resin, and phenol group resin. Among these, the epoxy group resin is preferrable.

In order to control the temperature of the pressure unit to fulfill these requirements, the following embodiments shown in Figs. 57 and 58 are provided.

In a thirty-eighth embodiment shown in Fig. 57, pressure roller 800 in a pressure unit is either heated or cooled by a heating/cooling means 802 so as to maintain a given temperature at which microcapsules on the sensitive sheets are easily ruptured. The heating/cooling means 802 transmit heat to the pressure roller 800, so that the the pressure roller provides the optimum temperature at which the microcapsules are easily rupturable. Uniform surface temperature of the pressure roller 800 is provided over entire peripheral surface thereof, and the temperature is preferably maintained regardless of the rotation of the rollers for a certain period of time. In order to provide such a constant temperature, a temperature sensor 803 is provided at a position immediately adjacent the outer peripheral surface of the pressure roller 800, and detection means 804 is connected to the sensor 803. The heating/cooling means 802 is connected to a control means 805 which is connected to the detection means 804. The temperature sensor 803 generates a signal indicative of the temperature of the pressure roller 800, and the signal is outputted to the detection means 804. In response to the signal, the detection means 804 provides an output signal to the control means 805, so that temperature feed-back is applied to the heating/cooling means 802. As a result, the pressure roller 800 provides the constant temperature. In the heating/cooling unit 802, one of halogen lamp, nichrome coil, and infrared lamp is used for heating, whereas Peltier element etc. is used for cooling.

With this arrangement, the sensitive sheet P carrying microcapsules and overlaid over the developer sheet 12 is heated or cooled when the sensitive sheet P passes through the pressure roller 800 whose surface temperature is controlled for facilitating rupture of the microcapsules. In this case, the developer sheet 12 is in contact with an opposing pressure roller 801. Therefore, the temperature of the pressure roller 800 is transmitted to the sensitive sheet P so that the sensitive sheet P provides optimum temperature for rupture of the microcapsules.

Fig. 58 shows a thirty-ninth embodiment for heating or cooling the sensitive sheet P. In this embodiment, a pressure roller 810 having a small diameter is provided. The pressure roller 810 is in rolling contact with a back-up roller 811 so as to apply sufficient pressure to the sensitive sheet P. Further, a heating/cooling means 802 is provided at an upstream side of the pressure roller 810. The heating/cooling means 802 is in contact with the pressure roller 810. Alternatively, this means 802 is slightly spaced away from the pressure roller 810. Similar to the embodiment shown in Fig. 57, the heating/cooling means 802 heats or cools the pressure roller 810 so as to permit the microcapsules to be easily ruptured at the transmitted temperature. Further, since the heating/cooling means 802 is positioned at the upstream side of the pressure roller 810 and confronting the sensitive sheet P, the heating/cooling means 802 provisionally heats or cools the sensitive sheet P before it is subjected to pressure by the pressure roller 810. Therefore, the microcapsules are heated or cooled to the optimum temperature for stabilized rupture thereof when the sheet P passes through the pressure roller 810.

## Claims

1. An image recording apparatus (1) including a light source (3, 54) for irradiating photo-sensitive and pressure sensitive recording medium (P) for forming a latent image on it and a pressure unit (8, 47) for developing an image on the photo-sensitive and pressure sensitive recording medium; characterised in that the apparatus includes control means (28, 57, 59, 62) for controlling the temperature and humidity condition of the environment around the photo-sensitive and pressure sensitive recording medium (P) so that development of the recording medium (P) is carried out under acceptable conditions.

2. An image recording apparatus according to claim 1, wherein the control means comprises a temperature control means (28) for controlling the temperature of the medium (P).

3. An image recording apparatus according to claim 2, wherein the temperature control means (28) comprises means for heating and cooling the ambient atmosphere surrounding the medium (P).

4. An image recording apparatus according to claim 1, 2 or 3 wherein means is provided to feed a developer material (12) to the pressure unit and the control means comprises a humidity control means (57, 59, 62) for controlling the humidity around the material (12).

5. An image recording apparatus according to claim 4, wherein the humidity control means (57, 59, 62) comprises means for lowering the humidity around the material (12).

6. An image recording apparatus according to any one of the preceding claims, wherein the control means comprises; detection means (441) for detecting ambient temperature or ambient humidity; and a heating or cooling means (404, 442) for changing the temperature or humidity in response to the temperature and humidity detected by the detection means (441).

7. An image recording apparatus according to claim 2 or any one of claims 3 to 6 when dependent upon claim 2, wherein the pressure unit comprises pressure rollers (8) and wherein the temperature control means comprises a cooling means (28) for cooling an outer peripheral surface of the pressure rollers with a cooling medium (21).

8. An image recording apparatus as defined in claim 2 or any one of claims 3 to 6 when dependent upon claim 2, wherein the pressure unit comprises pressure rollers (8) and wherein the temperature control means comprises a blower (B) for blowing cool air on to a surface of the sensitive recording medium (P) at a position upstream of the pressure rollers (8).

9. An image recording apparatus according to claims 4 or 5, wherein said pressure unit (8, 47) provides pressure contact between said photo-sensitive and pressure sensitive recording medium (P) and a developer member (12), said photo-sensitive and pressure sensitive recording medium (P) carrying a plurality of microcapsules each encapsulating therein a first colouring component, and said developer member (12) including a second colouring component which is reacted with said first colouring component for producing a colour image on said developer member corresponding to an original, wherein the control means controls the temperature and humidity condition of the environment around the photo-sensitive and pressure sensitive recording medium (P) and the developer member (12) at least before said photo-sensitive and pressure sensitive recording medium (P) and said developer member (12) pass through said pressure unit (8, 47) for applying pressure thereto.

## Patentansprüche

1. Bildaufnahmegerät (1), das eine Lichtquelle (3, 54) einschliesst, um ein photoempfindliches und druckempfindliches Aufnahmemedium (P) zu bestrahlen, um ein latentes Bild darauf zu bilden, und eine Druckeinheit (8, 47), um ein Bild auf dem photoempfindlichen und druckempfindlichen Aufnahmemedium zu bilden; dadurch gekennzeichnet, dass die Vorrichtung ein Kontrollmittel (28, 57, 59, 62) einschliesst, um den Temperatur- und Feuchtigkeitszustand der Umgebung des photoempfindlichen und druckempfindlichen Aufnahmemediums (P) zu kontrollieren, so dass die Entwicklung des Aufnahmemediums (P) unter akzeptierbaren Bedingungen durchgeführt wird.

2. Bildaufnahmegerät nach Anspruch 1, in dem das Kontrollmittel ein Temperaturkontrollmittel (28) zum Kontrollieren der Temperatur des Mediums (P) umfasst.

3. Bildaufnahmegerät nach Anspruch 2, in dem das Temperaturkontrollmittel (28) ein Mittel zum Erhitzen und Kühlen der umgebenden Atmosphäre, die das Medium (P) umgibt, umfasst.

4. Bildaufnahmegerät nach Anspruch 1, 2 oder 3, in dem ein Mittel vorgesehen ist, um ein Entwicklungsmaterial (12) an die Druckeinheit abzugeben, und das Kontrollmittel ein Feuchtigskeitkontrollmittel (57, 59, 62) umfasst, um die um dem Material (12) liegende Feuchtigkeit zu kontrollieren.

5. Bildaufnahmegerät nach Anspruch 4, in dem das Feuchtigkeitskontrollmittel (57, 59, 62) ein Mittel zum Verringern der um dem Material (12) liegenden Feuchtigkeit umfasst.

6. Bildaufnahmegerät nach einem der vorhergehenden Ansprüche, in dem das Kontrollmittel ein Feststellungsmittel (441) umfasst, um die umgebende Temperatur oder die umgebende Feuchtigkeit festzustellen; und ein Erhitzungs- oder Kühlmittel (402, 442), um die Temperatur oder Feuchtigkeit in Reaktion auf die von dem Feststellungsmittel (441) festgestellte Temperatur und Feuchtigkeit zu ändern.

7. Bildaufnahmegerät nach Anspruch 2 oder einem der Ansprüche 3 bis 6, wenn sie von Anspruch 2 abhängig sind, in dem die Druckeinheit Andruckrollen (8) umfasst, und in dem das Temperaturkontrollmittel ein Kühlmittel (28) umfasst, um eine äussere periphere Oberfläche der Andruckrollen mit einem Kühlmedium (21) zu kühlen.

8. Bildaufnahmegerät, das wie in Anspruch 2 oder einem der Ansprüche 3 bis 6 definiert ist, wenn diese von Anspruch 2 abhängen, in dem die Druckeinheit Andruckrollen (8) umfasst, und in dem das Temperaturkontrollmittel ein Gebläse (B) umfasst, um kühle Luft auf eine Oberfläche des empfindlichen Aufnahmemediums (P) an einer Stelle, die stromauf der Andruckrollen (8) liegt, zu blasen.

9. Bildaufnahmegerät nach Ansprüchen 4 oder 5, in dem die Druckeinheit (8, 47) Druckkontakt zwischen dem photoempfindlichen und druckempfindlichen Aufnahmemedium (P) und einem Entwicklungsglied (12) liefert, wobei das photoempfindliche und druckempfindliche Aufnahmemedium (P) eine Vielzahl von Mikrokapseln trägt, die je eine erste färbende Komponente darin einschliessen, und das Entwicklungsglied (12) eine zweite färbende Komponente einschliesst, die mit der ersten färbenden Komponente zur Reaktion gebracht wird, um ein einem Original entsprechendes Farbbild auf dem Entwicklungsglied zu bilden, in dem das Kontrollmittel den Temperatur- und Feuchtigskeitzustand der Umgebung des photoempfindlichen und druckempfindlichen Aufnahmemediums (P) und des Entwicklungsgliedes (12) wenigstens bevor das photoempfindliche und druckempfindliche Aufnahmemedium (P) und das Entwicklungsglied (12) durch die Druckeinheit (8, 47) gehen, um darauf Druck anzuwenden, kontrolliert.

## Revendications

1. Appareil d enregistrement d'images (1), comportant une source de lumière (3, 54) pour illuminer un milieu d'enregistrement (P) sensible à la lumière et à la pression pour former une image latente sur celui-ci, et une unité à pression (8, 47) pour développer une image sur le milieu d'enregistrement sensible à la lumière et à la pression, caractérisé en ce que l'appareil comporte des moyens de commande (28, 57, 59, 62) pour commander l'état de température et d'humidité de l'environnement du milieu d'enregistrement (P) sensible à la lumière et à la pression, de telle manière que le développement du milieu d'enregistrement (P) soit effectué dans des conditions acceptables.

2. Appareil d'enregistrement d'images selon la revendication 1, caractérisé en ce que les moyens de commande comprennent des moyens de commande de température (28) pour commander la température du milieu d'enregistrement (P).

3. Appareil d'enregistrement d'images selon la revendication 2, caractérisé en ce que les moyens de commande de température (28) comprennent des moyens pour chauffer et refroidir l'atmosphère ambiante entourant le milieu d'enregistrement (P).

4. Appareil d'enregistrement d'images selon la revendication 1, 2 ou 3, caractérisé en ce que des moyens sont prévus pour fournir une matière formant révéléteur (12) à l'unité à pression, et en ce que les moyens de commande comprennent des moyens de commande d'humidité (57, 59, 62) pour commander l'humidité autour de la matière formant révélateur (12).

5. Appareillage d'enregistrement d'images selon la revendication 4, caractérisé en ce que les moyens de commande d'humidité (57, 59, 62) comprennent des moyens pour diminuer l,humidité autour de la matière formant révélateur (12).

6. Appareil d'enregistrement d'images selon l'une des revendications précédentes, caractérisé en ce que les moyens de commande comprennent des moyens de détection (441) pour détecter la température ambiante au l'humidité ambiante, et des moyens de chauffage ou de refroidissement (404, 442) pour changer la température au l'humidité en réponse à la température et l'humidité détectés par les moyens de détection (441).

7. Appareil d'enregistrement d'images selon la revendications 2 l'une des revendication 3 à 6 lorsqu'elle dépend de la revendication 2, caractérisé en ce que l'unité à pression comprend des rouleaux presseurs (8), et en ce que les moyens de commande de température comprennent des moyens de refroidissement (28) pour refroidir une surface périphérique extérieure des rouleaux presseurs avec un milieu de refroidissement (21).

8. Appareil enregistreur d'images selon la revendication 2 ou l'une des revendications 3 à 6 lorsqu'elle dépend de la revendication 2, caractérisé en ce que l'unité à pression comprend des rouleaux presseurs (8), et en ce que les moyens de commande de température comprennent un ventilateur (B) pour souffler de l'air froid sur la surface du milieu d'enregistrement (P) à un emplacement situé en amont des rouleaux presseurs (8).

9. Appareil d'enregistrement d'images selon la revendication 4 ou 5, caractérisé en ce que ladite unité à pression (8, 47) assure un contact avec pression entre ledit milieu d'enregistrement (P) sensible à la lumière et à la pression et un organe formant révélateur (12), ledit milieu d'enregistrement (P) sensible à la lumière et à la pression portant une pluralité de microcapsules, chacune encapsulant dans elle-même un premier constituant colorant, et ledit organe formant révélateur (12) comportant un deuxième constituant colorant qui est mis en réaction avec ledit premier constituant colorant pour produire une image en couleur sur ledit organe formant révélateur, correspondant à un original, et en ce que les moyens de commande commandent l'état de température et d'humidité de l'environnement autour du milieu d'enregistrement (P) sensible à la lumière et à la pression et de l'organe formant révélateur (12) au moins avant que ledit milieu d'enregistrement (P) sensible à la lumière et à la pression et ledit organe formant révélateur (12) passent dans ladite unité à pression (8, 47) pour appliquer une pression à ceux-ci.
